# EUROPEAN PATENT APPLICATION

(11) **EP 4 757 073 A1**
(43) Date of publication of application: **10.06.2026**
(21) Application number: 24863116.0
(22) Date of filing: 28.08.2024
(51) Int. Cl.: H01Q 5/335, H01Q 5/50, H01Q 1/52, H01Q 1/48, H01Q 1/24, H05K 1/02, H01Q 5/30, H01Q 15/00

(54) **ELECTRONIC DEVICE INCLUDING ANTENNA**

(30) Priority: 04.09.2023 KR 20230117087; 27.09.2023 KR 20230130243
(71) Applicant: Samsung Electronics Co., Ltd., Suwon-si, Gyeonggi-do 16677 (KR)
(72) Inventor: CHOI, Donguk, Suwon-si Gyeonggi-do 16677 (KR); HWANG, Soonho, Suwon-si Gyeonggi-do 16677 (KR); KIM, Seunghwan, Suwon-si Gyeonggi-do 16677 (KR); SHIN, Sanggon, Suwon-si Gyeonggi-do 16677 (KR); CHUN, Jaebong, Suwon-si Gyeonggi-do 16677 (KR); HWANG, Hochul, Suwon-si Gyeonggi-do 16677 (KR)
(74) Representative: Gulde & Partner
(86) International application number: PCT/KR2024/012891
(87) International publication number: WO 2025/053535

(57) **Abstract**

An electronic device including an antenna is provided. The electronic device may include: at least one wireless communication circuit configured to provide a signal of a specified frequency band to a conductive portion operating as an antenna radiator; a first ground member arranged in a housing; a second ground member arranged in the housing; a first matching circuit arranged on a first feeding line for transmitting a first feeding signal of a first frequency band, the first feeding signal being provided to a first feeding point on the conductive portion, and grounded to the first ground member; a first filter connected to the first feeding point and grounded to the second ground member; a second matching circuit arranged on a second feeding line for transmitting a second feeding signal of a second frequency band, the second feeding signal being provided to a second feeding point on the conductive portion, and grounded to the first ground member; and a second filter connected to the second feeding point and grounded to the second ground member.

## Description

### [Technical Field]

The disclosure relates to an electronic device having an antenna, and relates to an electronic device including a metal member (a conductive member) operating as an antenna radiator.

### [Background Art]

The uses of electronic devices such as a bar type, a foldable type, a rollable type, and a sliding type of smartphone or tablet PC, are increasing, and various functions are being provided through electronic devices. An electronic device may perform wireless communication with another electronic device by using at least one antenna. For example, at least a part of a housing of an electronic device may be formed of a conductive member (e.g., a metal), and the electronic device may use the at least a part of the housing formed of a conductive member as an antenna (or a radiator, or an antenna radiator) for wireless communication. An electronic device may radiate signals of multiple frequency bands by providing multiple feeding signals to one conductive member.

### [DISCLOSURE OF INVENTION]

### [Solution to Problem]

An embodiment may provide an electronic device including: a housing 210 including a front plate 202 facing a front side of the electronic device, a rear plate 211 facing a rear side of the electronic device, and a side member 218 disposed between the front plate and the rear plate, the side member including a conductive portion operating as an antenna radiator; at least one wireless communication circuit 192 electrically connected to the conductive portion and configured to provide a signal of a designated frequency band; a first ground member 301 disposed in the housing; a second ground member 302 disposed in the housing so as to at least partially overlap the first ground member; a first matching circuit 310 which is disposed on a first feeding line configured to transmit a first feeding signal of a first frequency band provided from the at least one wireless communication circuit to a first feeding point on the conductive portion, and is grounded to the first ground member; and a first filter 312 connected to the first feeding point and grounded to the second ground member. In addition, the electronic device may include: a second matching circuit 320 which is disposed on a second feeding line configured to transmit a second feeding signal of a second frequency band provided from the at least one wireless communication circuit to a second feeding point on the conductive portion, and is grounded to the first ground member; and a second filter 322 connected to the second feeding point and grounded to the second ground member.

In addition, an embodiment may provide an electronic device including: a housing 210 including a side member 218, the side member including a conductive portion operating as an antenna radiator; at least one wireless communication circuit 192 electrically connected to the conductive portion and configured to provide a signal of a designated frequency band; a first ground member 301 disposed in the housing; a second ground member 302 disposed in the housing so as to at least partially overlap the first ground member; a first matching circuit 310 which is disposed on a first feeding line configured to transmit a first feeding signal of a first frequency band provided from the at least one wireless communication circuit to a first feeding point on the conductive portion, and is grounded to the first ground member; and a first filter 312 connected to the first feeding point and grounded to the second ground member. In addition, the electronic device may include: a second matching circuit 320 which is disposed on a second feeding line configured to transmit a second feeding signal of a second frequency band provided from the at least one wireless communication circuit to a second feeding point on the conductive portion, and is grounded to the second ground member; and a second filter 322 connected to the second feeding point and grounded to the first ground member.

In addition, an embodiment may provide an electronic device including: a housing 210 including a side member 218, the side member including a conductive portion operating as an antenna radiator; at least one wireless communication circuit 192 electrically connected to the conductive portion and configured to provide a signal of a designated frequency band; a first ground member 301 disposed in the housing; a second ground member 302 disposed to at least partially overlap the first ground member; a third ground member 303 disposed to overlap at least one of the first ground member or the second ground member; a first matching circuit 310 which is disposed on a first feeding line configured to transmit a first feeding signal of a first frequency band provided from the at least one wireless communication circuit to a first feeding point on the conductive portion, and is grounded to the first ground member; and multiple first filters 312-1 and 312-2 connected to the first feeding point and grounded to the second ground member and the third ground member, respectively. The multiple first filters 312-1 and 312-2 may be respectively grounded to the second ground member and the third ground member so as to respectively correspond thereto. For example, a (1-1)th filter 312-1 of the multiple first filters 312-1 and 312-2 may be connected to the second ground member, and a (1-2)th filter 312-2 of the multiple first filters 312-1 and 312-2 may be connected to the third ground member. In addition, the electronic device may include: a second matching circuit 320 which is disposed on a second feeding line configured to transmit a second feeding signal of a second frequency band provided from the at least one wireless communication circuit to a second feeding point on the conductive portion, and is grounded to the first ground member; multiple second filters 322-1 and 322-2 connected to the second feeding point and grounded to the second ground member and the third ground member, respectively; a third matching circuit 340 which is disposed on a third feeding line configured to transmit a third feeding signal of a third frequency band provided from the at least one wireless communication circuit to a third feeding point on the conductive portion, and is grounded to the first ground member; and multiple third filters 332-1 and 332-2 connected to the third feeding point and grounded to the second ground member and the third ground member, respectively.

### [BRIEF DESCRIPTION OF DRAWINGS]

FIG. 1 is a block diagram of an electronic device in a network environment according to various embodiments.
FIG. 2A is a perspective view when viewing the front surface of an electronic device according to an embodiment.
FIG. 2B is a perspective view when viewing the rear surface of the electronic device in FIG. 2A.
FIG. 3 is a view showing an example in which multiple feeding signals are provided to a side surface member operating as an antenna radiator of an electronic device according to an embodiment.
FIG. 4 is a cross-sectional view showing a portion in which a first ground member, a second ground member, a first matching circuit, a first filter, and an antenna radiator of an electronic device are connected to each other according to an embodiment.
FIG. 5A is a view showing an electrical path in which a first feeding signal is transmitted to a second ground member through an antenna radiator according to an embodiment.
FIG. 5B is a view showing an electrical path in which a second feeding signal is transmitted to a second ground member through an antenna radiator according to an embodiment.
FIG. 6 is a view showing a distribution of an H-field formed on a first ground member with reference to a first feeding point and a second feeding point according to an embodiment.
FIG. 7 is a view showing an example of a connection point on a first ground member according to an embodiment of the disclosure.
FIG. 8 is a view showing an example in which a switch is disposed at a connection point on a first ground according to an embodiment of the disclosure.
FIG. 9 is a view showing performance of an antenna radiator when a first feeding signal and a second feeding signal are fed to the antenna radiator according to an embodiment of the disclosure.
FIG. 10A is a view showing an example in which a first matching circuit, a first filter, a second matching circuit, and a second filter are connected to a first ground member and a second ground member according to an embodiment.
FIG. 10B is a view showing an example in which a first matching circuit, a first filter, a second matching circuit, and a second filter are connected to a first ground member and a second ground member according to an embodiment.
FIG. 10C is a view showing an example in which a first matching circuit, a first filter, a second matching circuit, and a second filter are connected to a first ground member and a second ground member according to an embodiment.
FIG. 11 is a view showing an example in which a ground member and an antenna radiator, to which a first feeding signal and a second feeding signal are fed, are arranged, in an electronic device according to an embodiment.
FIG. 12 is a view showing an example in which a first matching circuit, a first filter, a second matching circuit, a second filter, a first ground member, a second ground member, and an antenna radiator are arranged when an electronic device is viewed from the front side of the electronic device according to an embodiment.
FIG. 13 is a view showing an example in which a first matching circuit, a first filter, a first ground member, a second ground member, and an antenna radiator are arranged when an electronic device is viewed from the side surface of the electronic device according to an embodiment.
FIG. 14A is a view showing an example of a first ground member and a second ground member according to an embodiment.
FIG. 14B is a view showing an example of a first ground member and a second ground member according to an embodiment.
FIG. 14C is a view showing an example of a first ground member and a second ground member according to an embodiment.
FIG. 14D is a view showing an example of a first ground member and a second ground member according to an embodiment.
FIG. 14E is a view showing an example of a first ground member and a second ground member according to an embodiment.
FIG. 14F is a view showing an example of a first ground member and a second ground member according to an embodiment.
FIG. 15 is a view showing an example of a switch disposed at a connection point of a first ground member, to which a second ground member is connected, when an electronic device is viewed from the front side of the electronic device according to an embodiment.
FIG. 16 is a view showing an example in which a first ground member and a second ground member are connected to each other through an FPCB according to an embodiment.
FIG. 17 is a view showing an example in which three feeding signals are provided to an antenna radiator according to an embodiment.

### [MODE FOR THE INVENTION]

In the following, embodiments of the disclosure will be described in detail with reference to the accompanying drawings so as to enable the disclosure to be easily implemented by a person skilled in the art to which the disclosure belongs. However, the disclosure may be implemented in various different forms and is not limited to the embodiments described herein. In addition, in order to clearly explain the disclosure in the drawings, portions irrelevant to the description have been omitted, and similar reference numerals are assigned to similar parts throughout the specification.

The terms used in the disclosure may be expressed as generally used terms in light of the functions mentioned in the disclosure, but may be understood to mean various other terms according to the intent of a person skilled in the art, judicial precedents, or the emergence of new technology. Therefore, the terms used in the disclosure should not be interpreted based only on their names, but should be interpreted based on the meanings of the terms and the overall content of the disclosure.

In addition, the terms "first", "second", and the like may be used for describing various elements, but the elements should not be limited by the terms. The terms are used for a purpose of distinguishing one element from another element.

Throughout the specification, when it is stated that a portion is "connected" to another portion, this includes not only a case where the portion is "directly connected" but also a case where the portion is "electrically connected" with another element interposed therebetween. In addition, when it is described that a portion "includes" an element, it means that the portion may further include other elements in addition to the element, unless the contrary is specifically stated.

The term "an embodiment" or similar expressions appearing in various places in the disclosure does not necessarily refer to the same embodiment.

Functional blocks and various processing steps may be used to represent an embodiment of the disclosure. A part or all of the functional blocks may be implemented by various numbers of hardware configurations and/or software configurations which perform specific functions. For example, the functional blocks of the disclosure may be implemented by one or more microprocessors, or by circuit configurations for predetermined functions. In addition, for example, the functional blocks of the disclosure may be implemented in various programming or scripting languages. The functional blocks may be implemented as an algorithm executed by one or more processors. In addition, the disclosure may employ conventional technology for electronic environment configuration, signal processing, and/or data processing. Terms such as "mechanism", "element", "means", and "configuration" may be used in a broad sense and are not limited to mechanical and physical elements.

In addition, the connection lines or connection members between the elements illustrated in the drawings are merely exemplary of functional, and/or physical or circuit connections. In an actual device, the connections between elements may be represented by various functional, physical, or circuit connections which are replaceable or added.

Hereinafter, the disclosure will be described in detail with reference to the accompanying drawings.

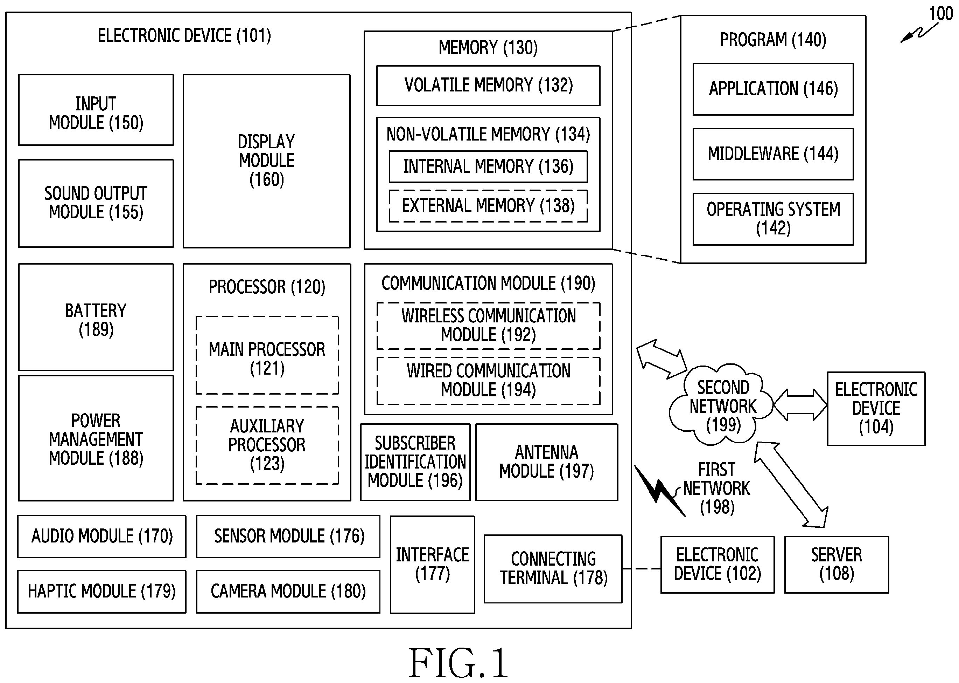

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted Boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adjacent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

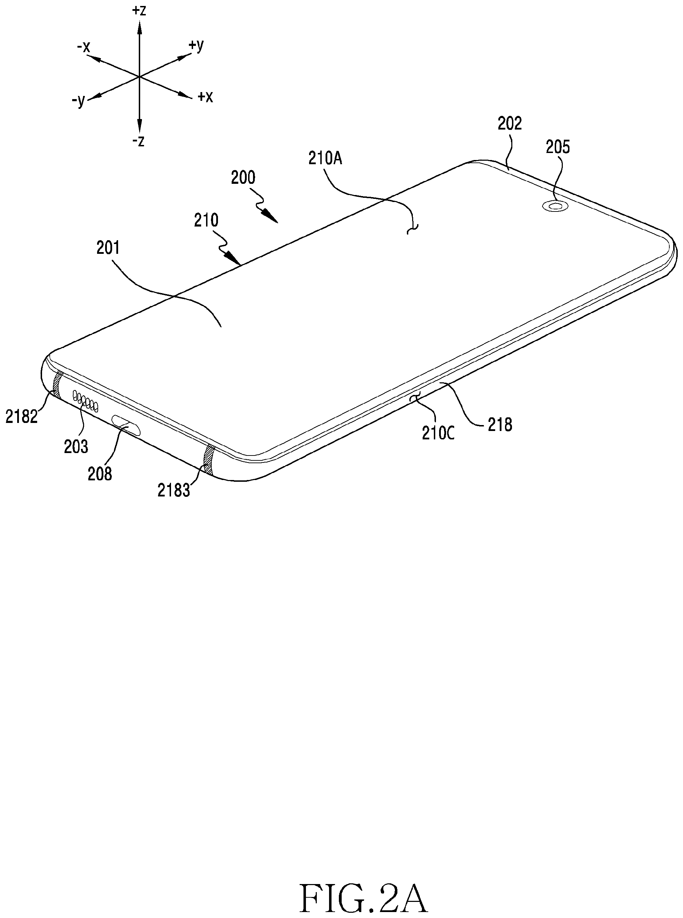

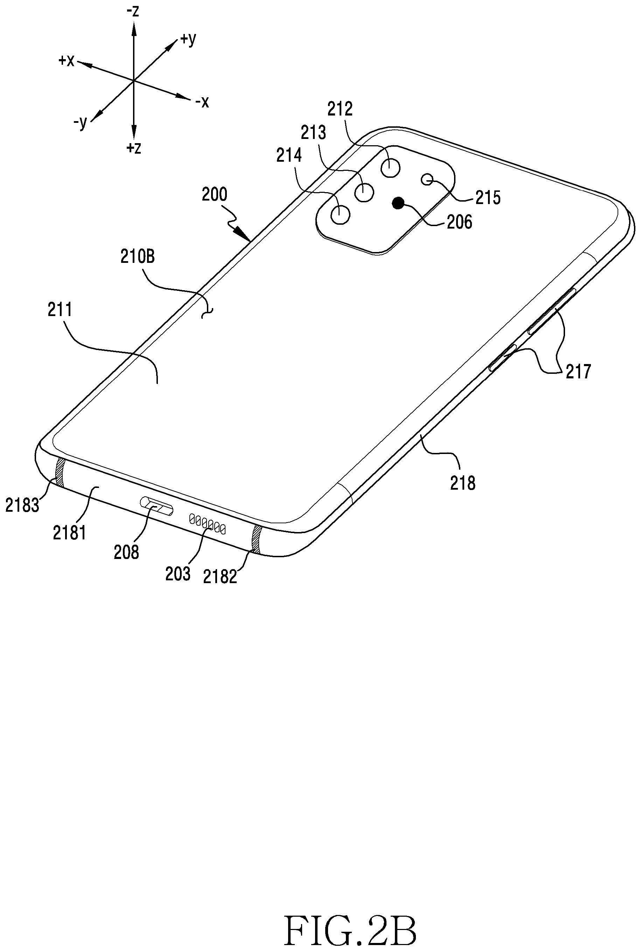

FIG. 2A is a perspective view when viewing the front surface of an electronic device according to an embodiment, and FIG. 2B is a perspective view when viewing the rear surface of the electronic device in FIG. 2A.

Referring to FIGS. 2A and 2B, an electronic device 200 (e.g., the electronic device 101 in FIG. 1) according to an embodiment may include a housing 210 including a first surface (or a front surface) 210A, a second surface (or a rear surface) 210B, and a side surface (or a side wall) 210C which surrounds a space between the first surface 210A and the second surface 210B. In an0other embodiment (not shown), the housing 210 may also refer to a structure which forms a part of the first surface 210A, the second surface 210B, and the side surface 210C in FIG. 2A and FIG. 2B.

According to an embodiment, at least a portion of the first surface 210A may be formed by a front plate 202 (e.g., a "cover window") (e.g., a polymer plate or a glass plate including various coating layers) which is substantially transparent. According to an embodiment, the front plate 202 may include a curved-surface portion which is bent from the first surface 210A toward a rear plate 211 at least at one side edge portion and extends seamlessly.

According to an embodiment, the second surface 210B may be formed by the rear plate 211 which is substantially opaque. For example, the rear plate 211 may be formed by coated or colored glass, ceramic, polymer, metal (e.g., aluminum, stainless steel (STS), or magnesium), or a combination of at least two of the above materials. According to an embodiment, the rear plate 211 may include a curved-surface portion which is bent from the second surface 210B toward the front plate 202 at least at one side end portion and seamlessly extends.

According to an embodiment, the side surface 210C may be formed by a side member (or "bracket") 218 which is coupled to the front plate 202 and the rear plate 211 and includes a metal and/or a polymer. In some embodiments, the rear plate 211 and the side member 218 may be integrally formed and may include the same material (e.g., a metal material such as aluminum). In an example, the side member 218 may include a conductive portion 2181 and/or at least one non-conductive portion 2182 and 2183. For example, a first non-conductive portion 2182 may be disposed at one end (e.g., one end in the -x-axis direction) of the conductive portion 2181 and a second non-conductive portion 2183 may be disposed at the other end (e.g., one end in the +x-axis direction) of the conductive portion 2181, so that the conductive portion 2181 can be electrically isolated. In another example, the conductive portion 2181 may be fed from a wireless communication circuit (e.g., the wireless communication module 192 in FIG. 1) and thus may operate as an antenna radiator for transmitting and/or receiving an RF signal of a designated frequency band.

According to an embodiment, the electronic device 200 may include at least one of a display 201, an audio module 203, a sensor module (not shown), a camera module 205, 212, 213, 214, 215, or 206, key input devices 217, or a connector hole 208. In some embodiments, at least one (e.g., a key input device 217) of elements may be omitted from the electronic device 200, and other elements may be additionally included in the electronic device.

In some embodiments, the electronic device 200 may further include a light emitting element, and the light emitting element may be disposed at a position adjacent to the display 201 in a region provided by the front plate 202. For example, the light emitting element may provide state information of the electronic device 200 in the form of light. In another embodiment, for example, the light emitting element may provide a light source which operates in conjunction with an operation of the camera module 205. For example, the light emitting element may include an LED, an IR LED, and a xenon lamp.

According to an embodiment, the display 201 may be visible from the outside of the electronic device 200 through a substantial portion of the front plate 202. In some embodiments, an edge of the display 201 may be formed to be substantially the same as the shape (e.g., a curved surface) of the outer edge, which is adjacent to the edge, of the front plate 202. In another embodiment (not shown), in order to expand an area where the display 201 is exposed, the gap between the outer edge of the display 201 and the outer edge of the front plate 202 may be formed to be substantially uniform. In another embodiment (not shown), the electronic device 200 may have a recess or an opening formed in a part of a screen display region of the display 201, and may include another electronic component, for example, a camera module 205, or a proximity sensor or an illuminance sensor not shown, which is aligned with the recess or the opening.

In another embodiment (not shown), at least one of the camera modules 212, 213, 214, and 215, a fingerprint sensor (not shown), and a flash 206 may be included in a rear surface of the screen display region of the display 201. In another embodiment (not shown), the display 201 may be coupled to or disposed adjacent to a touch detection circuit, a pressure sensor capable of measuring the intensity (pressure) of a touch, and/or a digitizer for detecting a magnetic-field-type stylus pen.

According to an embodiment, the audio module 203 may include a microphone hole and/or a speaker hole. The microphone hole may have a microphone disposed therein to acquire external sound, and in some embodiments, multiple microphones may be arranged to detect the direction of sound. In some embodiments, a speaker hole and a microphone hole may be implemented as a single hole, or a speaker without a speaker hole may be included (e.g., a piezo speaker). The speaker hole may include an external speaker hole and/or a receiver hole for calling.

According to an embodiment, the electronic device 200 may include a sensor module not shown, and thus may generate an electrical signal or data value corresponding to an internal operating state or an external environmental state. For example, the sensor module may further include a proximity sensor disposed on the first surface 210A of the housing 210, a fingerprint sensor integrated into or disposed adjacent to the display 201, and/or a biometric sensor (e.g., an HRM sensor) disposed on the second surface 210B of the housing 210. The electronic device 200 may further include at least one of sensor module not shown, for example, a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, or an illuminance sensor.

According to an embodiment, the camera modules 205, 212, 213, 214, 215, and 206 may include a first camera device 205 disposed on the first surface 210A of the electronic device 200, and a second camera devices 212, 213, 214, and 215 and/or a flash 206 arranged on a second surface 210B. In an embodiment, the camera device 205, 212, 213, 214, or 215 described above may include one lens or multiple lenses, an image sensor, and/or an image signal processor. In another example, the flash 206 may include a light emitting diode or a xenon lamp. In some embodiments, two or more lenses (e.g., an infrared camera, a wide-angle lens and a telephoto lens) and image sensors may be arranged on one surface of the electronic device 200.

According to an embodiment, the key input devices 217 may be arranged on the side surface 210C of the housing 210. In another embodiment, the electronic device 200 may not include a part or all of the above-mentioned key input devices 217, and a key input device 217 not included may be implemented in another form, such as a soft key, on the display 201. In some embodiments, the key input devices may include at least a part of a fingerprint sensor disposed on the second surface 210B of the housing 210.

According to an embodiment, the connector hole 208 may accommodate a connector for transmitting and receiving power and/or data to and from an external electronic device, and/or a connector for transmitting and receiving an audio signal to and from an external electronic device. For example, the connector hole 208 may include a USB connector or an earphone jack. In an embodiment, the USB connector and the earphone jack may also be implemented as a single hole (e.g., 208 in FIG. 2A and FIG. 2B). According to another embodiment (not shown), the electronic device 200 may transmit and receive power and/or data or may also transmit and receive an audio signals, with an external electronic device (e.g., the electronic devices 102 and 104 in FIG. 1) without a separate connector hole.

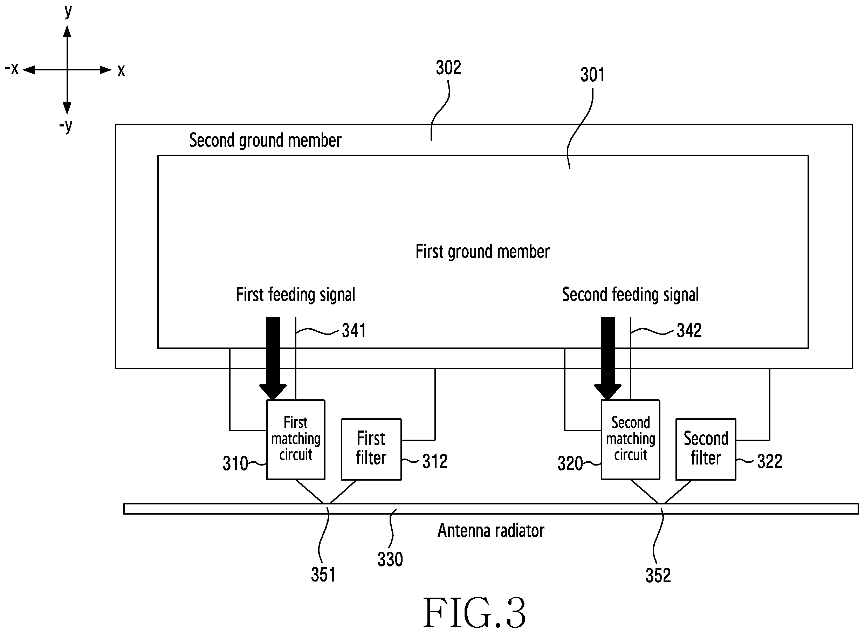

FIG. 3 is a view showing an example in which multiple feeding signals are provided to a side surface member operating as an antenna radiator of an electronic device according to an embodiment.

Referring to FIG. 3, an electronic device 101 according to an embodiment may include a first ground member 301, a second ground member 302, a first matching circuit 310, a first filter 312, a second matching circuit 320, a second filter 322, and an antenna radiator 330.

According to an embodiment, the first ground member 301 may be a ground member connected to at least one of the first matching circuit 310, the first filter 312, the second matching circuit 320, or the second filter 322. The first ground member 301 may include at least a part of components in the electronic device 101. For example, the first ground member 301 may include at least one of a printed circuit board (PCB), a support member (e.g., a front metal), a laser direct structuring (LDS)-based member, a speaker device, a motor device, or a grip pad, but is not limited thereto. For example, when the first ground member 301 is a PCB having a laminated structure in which a dielectric layer and a metal plating layer are alternately and repeatedly laminated, a fill cut region in which a part of the plating layer in the first ground member 301 is removed may be a non-ground region, and a region (e.g., the plating layer) other than the fill cut region may be a ground region.

According to an embodiment, the second ground member 302 may be a ground member connected to at least one of the first matching circuit 310, the first filter 312, the second matching circuit 320, or the second filter 322. The second ground member 302 may include at least a part of components in the electronic device 101. For example, the second ground member 302 may include at least one of a printed circuit board (PCB), a support member (e.g., a front metal), a laser direct structuring (LDS)-based member, a speaker device, a motor device, or a grip pad, but is not limited thereto. For example, when the second ground member 302 is a PCB having a laminated structure in which a dielectric layer and a metal plating layer are alternately and repeatedly laminated, a fill cut region in which a part of the plating layer in the second ground member 302 is removed may be a non-ground region, and a region (e.g., the plating layer) other than the fill cut region may be a ground region.

According to an embodiment, the first matching circuit 310 and the first filter 312 may be respectively grounded to different ground members among the first ground member 301 and the second ground member 302. According to an embodiment, the second matching circuit 320 and the second filter 322 may be respectively grounded to different ground members among the first ground member 301 and the second ground member 302.

According to an embodiment, at least a part of the first ground member 301 may be disposed to overlap the second ground member 302. For example, when viewed in the -z-axis direction in FIG. 2A, at least a part of the first ground member 301 may be disposed to overlap the second ground member 302. The first ground member 301 and the second ground member 302, which are arranged to overlap each other, may be electrically connected to each other through one or more connection points.

Although it has been described above that at least a part of the first ground member 301 overlaps the second ground member 302, it is not limited thereto. For example, the first ground member 301 may be disposed so as not to overlap the second ground member 302. In this case, the first ground member 301 and the second ground member 302 may be disposed adjacent to each other, but are not limited thereto.

According to an embodiment, the first matching circuit 310 may be disposed to adjust a length of an electrical path of the antenna radiator 330 which radiates a first feeding signal of a first frequency band. For example, the first matching circuit 310 may be disposed on a feeding line 341 which transmits a first feeding signal from a wireless communication circuit (e.g., the wireless communication module 192 in FIG. 1) to the antenna radiator 330, and the first matching circuit 310 may be grounded to the first ground member 301. For example, the first matching circuit 310 may be disposed near a first feeding point 351 on the feeding line 341 from the wireless communication circuit to the first feeding point 351.

According to an embodiment, the first ground member 301 may include a PCB, and the first matching circuit 310 may be disposed at a position adjacent to the first feeding point 351 on the PCB and be grounded to the first ground member 301. For example, the first matching circuit 310 may also be disposed on another PCB. For example, when the first ground member 301 includes a PCB, the wireless communication circuit (e.g., the wireless communication module 192 in FIG. 1) may be disposed on the PCB or on another PCB. For example, the first matching circuit 310 may include at least one capacitance and/or at least one inductance.

According to an embodiment, for example, the first frequency band may be a frequency band for global positioning system (GPS) communication, a frequency band for Bluetooth communication, or a frequency band for 5rd generation (5G) communication, but is not limited thereto. In addition, for example, the first frequency band may be 824 - 960 MHz frequency band or 1710 - 2170 MHz frequency band, but is not limited thereto. In addition, for example, the first frequency band and the second frequency band may not overlap each other, and a gap between the first frequency band and the second frequency band may be greater than at least 800 MHz.

According to an embodiment, the first filter 312 may be disposed in order to remove frequency interference from other feeding signals other than the first feeding signal. For example, the first filter 312 may be disposed in order to remove frequency interference from a second feeding signal other than a first feeding signal. In an embodiment, the first filter 312 may be grounded to the second ground member 302 other than the first ground member 301. For example, the first filter 312 may be positioned between the first feeding point 351 and the second ground member 302. For example, the first ground member 301 may include a PCB, and the first filter 312 may be disposed at a position adjacent to the first feeding point 351 on the PCB and be grounded to the second ground member 302.

According to an embodiment, the first filter 312 may be formed to allow a second feeding signal of a second frequency band to pass through to the second ground member 302. The second feeding signal may be a signal of the second frequency band, and the second feeding signal flowing through the antenna radiator 330 may pass through to the second ground member 302 through the first filter 312.

According to an embodiment, the second matching circuit 320 may be disposed to adjust a length of an electrical path of the antenna radiator 330 which radiates the second feeding signal of the second frequency band. For example, the second matching circuit 320 may be disposed on a feeding line 342 which transmits a second feeding signal from a wireless communication circuit (e.g., the wireless communication module 192 in FIG. 1) to the antenna radiator 330, and the second matching circuit 320 may be grounded to the first ground member 301. For example, the second matching circuit 320 may be disposed near a second feeding point 352 on the feeding line 342 from the wireless communication circuit to the second feeding point 352.

According to an embodiment, the first ground member 301 may include a PCB, and the second matching circuit 320 may be disposed at a position adjacent to the second feeding point 352 on the PCB and be grounded to the first ground member 301. Alternatively, the second matching circuit 320 may also be disposed on another PCB other than the PCB. For example, when the first ground member 301 includes a PCT, the wireless communication circuit (e.g., the wireless communication module 192 in FIG. 1) may be disposed on the PCB or on another PCB. For example, the second matching circuit 320 may include at least one capacitance and/or at least one inductance.

According to an embodiment, for example, the second frequency band may be a frequency band for GPS communication, a frequency band for Bluetooth communication, or a frequency band for 5G communication, but is not limited thereto. In addition, for example, the second frequency band may be 824 - 960 MHz frequency band or 1710 - 2170 MHz frequency band, but is not limited thereto. In addition, for example, the first frequency band and the second frequency band may not overlap each other, and a gap between the first frequency band and the second frequency band may be greater than at least 800 MHz. For example, the first frequency band may be a frequency band for GPS communication, and the second frequency band may be a frequency band for Bluetooth communication. Alternatively, for example, the first frequency band may be a frequency band for Bluetooth communication, and the second frequency band may be a frequency band for 5G communication. Alternatively, for example, the first frequency band may be a reception frequency band of 824 - 960 MHz, and the second frequency band may be a reception frequency band of 1710 - 2170 MHz.

According to an embodiment, the second filter 322 may be disposed in order to remove frequency interference from other feeding signals other than the second feeding signal. For example, the second filter 322 may be disposed in order to remove frequency interference from the first feeding signal other than the second feeding signal. In an embodiment, the second filter 322 may be grounded to the second ground member 302 other than the first ground member 301. For example, the second filter 322 may be disposed between the second feeding point 352 and the second ground member 302. For example, the first ground member 301 may include a PCB, and the first filter 312 may be disposed at a position adjacent to the second feeding point 352 on the PCB and be grounded to the second ground member 302.

According to an embodiment, the second filter 322 may be formed to allow the first feeding signal of the first frequency band to pass through to the second ground member 302. The first feeding signal may be a signal of the first frequency band, and the first feeding signal flowing through the antenna radiator 330 may pass through to the second ground member 302 through the second filter 322.

According to an embodiment, as the first matching circuit 310 and the first filter 312 are respectively grounded to different ground members and the second matching circuit 320 and the second filter 322 are respectively grounded to different ground member, in a state where an RF signal is fed to the antenna radiator 330 to be described below through single feeding and/or multiple feeding, signal interference between the first matching circuit 310 and the first filter 312 and/or signal interference between the second matching circuit 320 and the second filter 322 may be reduced.

According to an embodiment, at least a part of the side member 218 in FIG. 2A may be used as the antenna radiator 330. For example, the antenna radiator 330 may correspond to the conductive portion 2181 of the side member 218 in FIG. 2A, but is not limited thereto. The antenna radiator 330 may be another conductive portion included in the side member 218 in FIG. 2A.

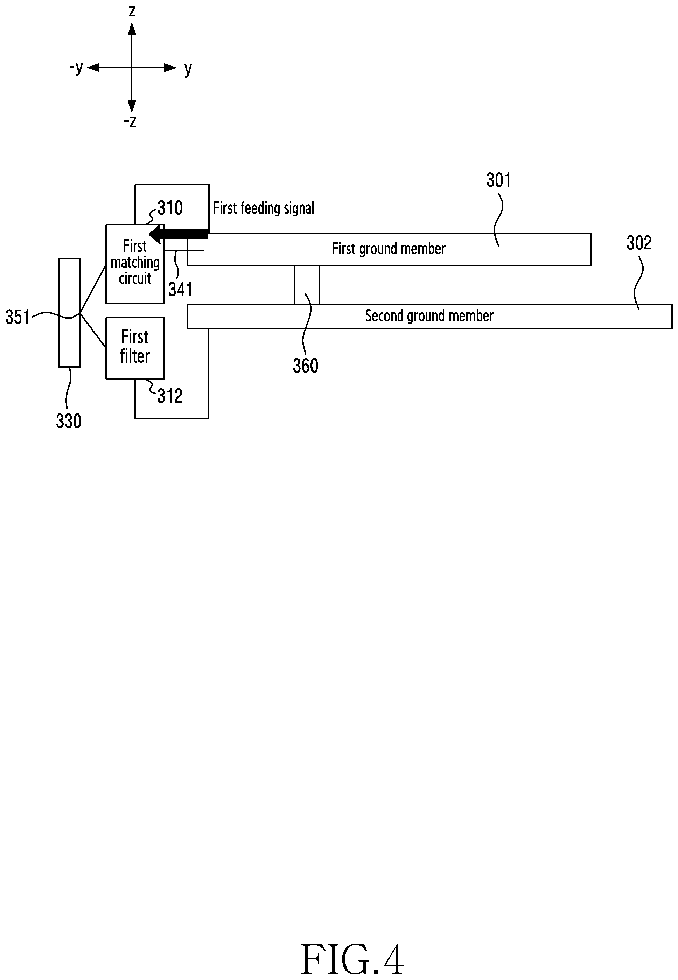

FIG. 4 is a cross-sectional view showing a portion in which a first ground member, a second ground member, a first matching circuit, a first filter, and an antenna radiator of an electronic device are connected to each other according to an embodiment.

According to an embodiment, FIG. 4 may show an example in which the first ground member 301, the second ground member 302, the first matching circuit 310, the first filter 312, and the antenna radiator 330 are connected to each other when the electronic device 101 is viewed in the x-axis direction in FIG. 2A.

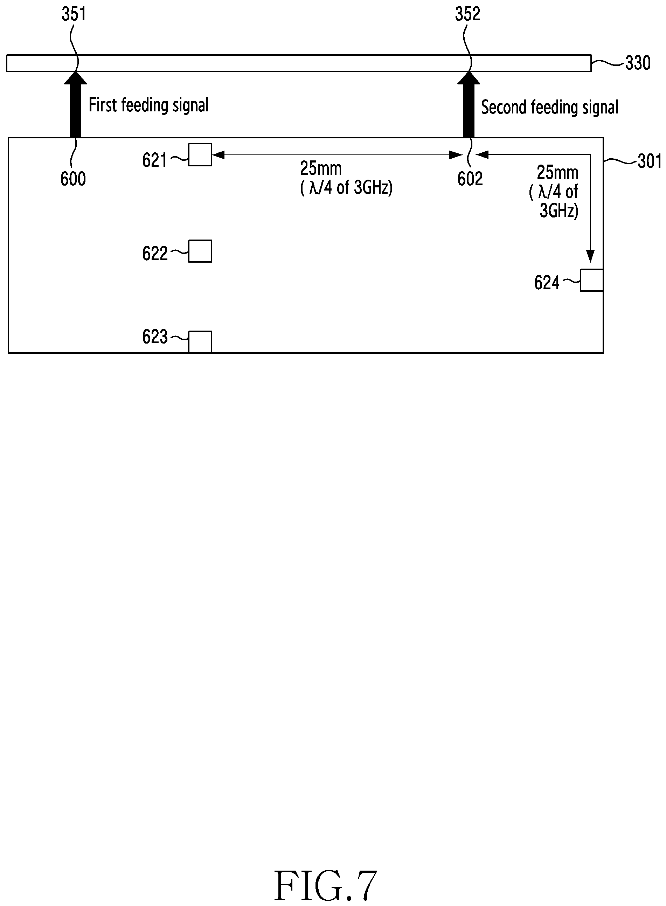

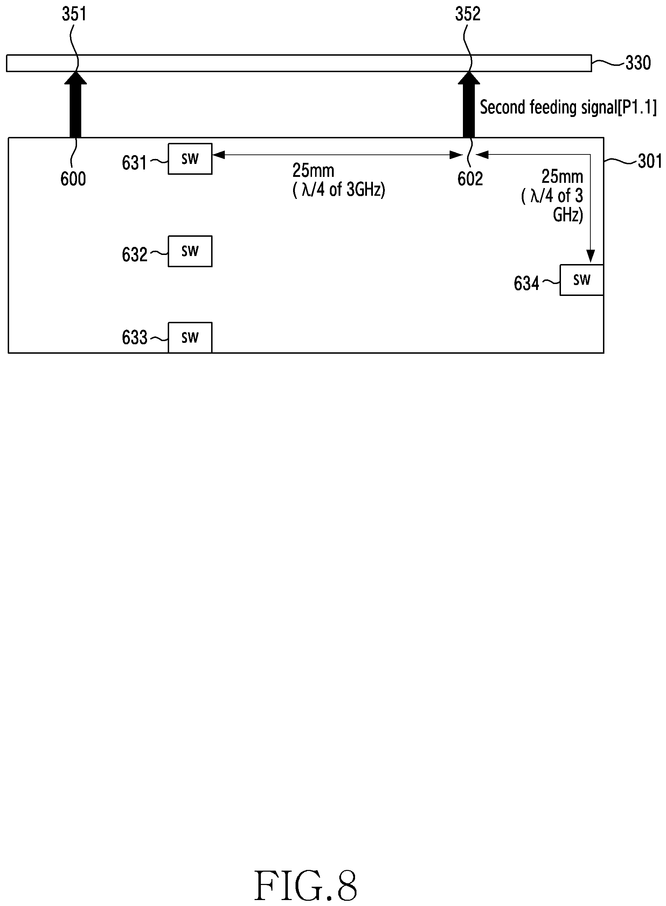

Referring to FIG. 4, the first ground member 301 and the second ground member 302 according to an embodiment may be arranged as a laminated structure. For example, at least a part of the first ground member 301 may be laminated with the second ground member 302 when the electronic device 101 is viewed in the -z-axis direction. The first ground member 301 and the second ground member 302 may be electrically connected to each other through a connection member 360. The example in which the first ground member 301 and the second ground member 302 are connected to each other through the connection member 360 will be described in more detail with reference to FIG. 7 and FIG. 8.

According to an embodiment, the first matching circuit 310 may be positioned on the feeding line 341 which transmits the first feeding signal from a wireless communication circuit (e.g., the wireless communication module 192 in FIG. 1) to the first feeding point 351 of the antenna radiator 330. In addition, the first matching circuit 310 may be grounded to the first ground member 301.

According to an embodiment, the first filter 312 may be connected to the first feeding point 351 of the antenna radiator 330 and be grounded to the second ground member 302.

In the above description, the first ground member 301 and the second ground member 302 are described as separate members connected to each other through the connection member 360, but are not limited thereto. For example, the first ground member 301 and the second ground member 302 may also be formed to be distinguished from each other in a single member.

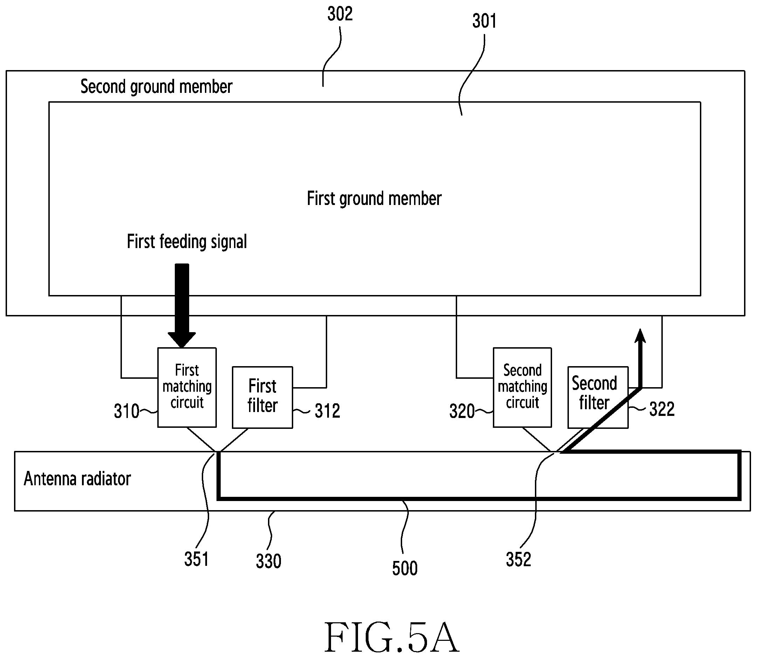

FIG. 5A is a view showing an electrical path in which a first feeding signal is transmitted to a second ground member through an antenna radiator according to an embodiment.

Referring to FIG. 5A, for example, the first feeding signal of the first frequency band may be fed to the first feeding point 351 of the antenna radiator 330. The first feeding signal fed to the first feeding point 351 of the antenna radiator 330 may flow to the second ground member 302 via the second filter 322 along an electrical path 500. In this case, the first feeding signal may be a signal of the first frequency band, and the second filter 322 may be a filter which passes a signal of the first frequency band to the second ground member 302.

In addition, for example, the first filter 312 may be a filter which passes a second feeding signal of a second frequency band to the second ground member 302, and since the first feeding signal of the first frequency band cannot pass through the first filter 312 and then flow to the second ground member 302, the first feeding signal of the first frequency band may be blocked from passing through to the second ground member 302 by the first filter 312. In addition, for example, the second filter 322 may pass a signal of the first frequency band toward the second ground member 302, and the second filter 322 may block a signal of a frequency band not included in the first frequency band from flowing to the second ground member 302.

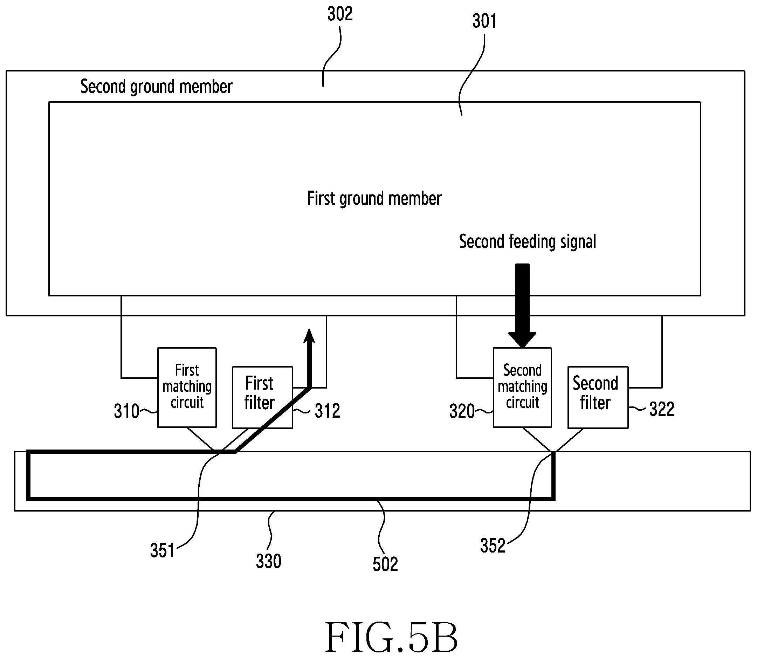

FIG. 5B is a view showing an electrical path in which a second feeding signal is transmitted to a second ground member through an antenna radiator according to an embodiment.

Referring to FIG. 5B, for example, the second feeding signal of the second frequency band may be fed to the second feeding point 352 of the antenna radiator 330. The second feeding signal fed to the second feeding point 352 of the antenna radiator 330 may flow to the second ground member 302 via the first filter 312 along an electrical path 502. In this case, the second feeding signal may be a signal of the second frequency band, and the first filter 312 may be a filter which passes a signal of the second frequency band to the second ground member 302.

In addition, for example, the second filter 322 may be a filter which passes a first feeding signal of a first frequency band to the second ground member 302, and since the second feeding signal of the second frequency band cannot pass through the second filter 322 and then flow to the second ground member 302, the second feeding signal of the second frequency band may be blocked from passing through to the second ground member 302 by the second filter 322. In addition, for example, the first filter 312 may pass a signal of the second frequency band toward the second ground member 302, and may block a signal of a frequency band not included in the second frequency band from flowing to the second ground member 302.

According to an embodiment, as the first matching circuit 310 and the first filter 312 are respectively grounded to different ground members, when the first feeding signal and the second feeding signal are fed to the antenna radiator 330 through multiple feeding, the occurrence of interference between the first matching circuit 310 and the first filter 312 adjacent to each other may be reduced. For example, the occurrence of interference between an inductor and/or a capacitor in the first matching circuit 310 and an inductor and/or a capacitor in the first filter 312 may be reduced. In addition, as the second matching circuit 320 and the second filter 322 are respectively grounded to different ground members, when the first feeding signal and the second feeding signal are fed to the antenna radiator 330 through multiple feeding, the occurrence of interference between the second matching circuit 320 and the second filter 322 adjacent to each other may be reduced. For example, the occurrence of interference between an inductor and/or a capacitor in the second matching circuit 320 and an inductor and/or a capacitor in the second filter 322 may be reduced.

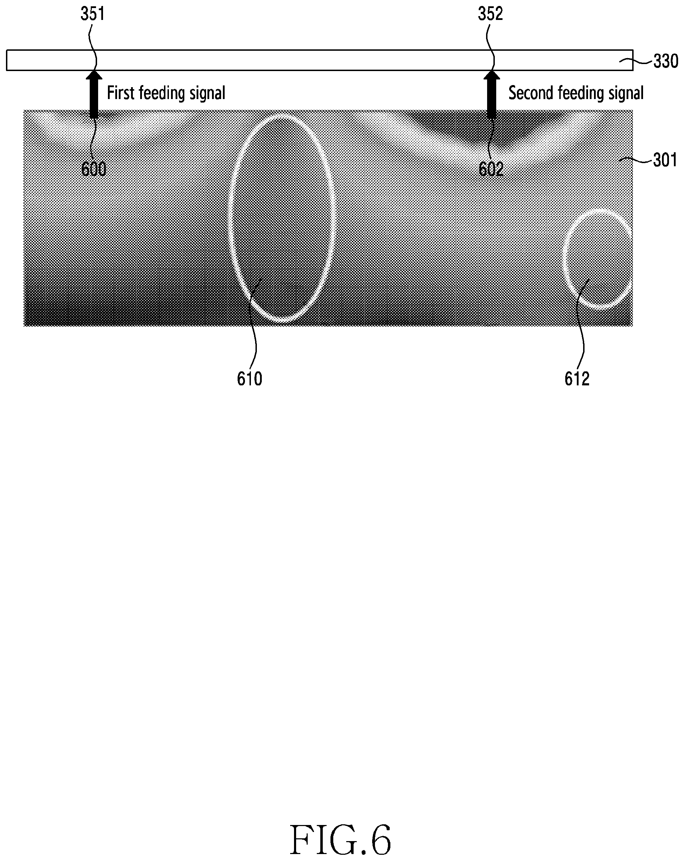

FIG. 6 is a view showing a distribution of an H-field formed on a first ground member with reference to a first feeding point and a second feeding point according to an embodiment.

Referring to FIG. 6, for example, a first feeding signal of the first frequency band may be fed to the first feeding point 351 of the antenna radiator 330, and the second feeding signal of the second frequency band may be fed to the second feeding point 352 of the antenna radiator 330.

In addition, on the first ground member 301, an H-field may be formed from a first point 600 corresponding to the first feeding point 351, and an H-field may be formed from a second point 602 corresponding to the second feeding point 352. In this case, for example, the second frequency band may be a frequency band higher than the first frequency band. In addition, for example, a gap between the first frequency band and the second frequency band may be greater than at least 800 MHz.

According to an embodiment, the second frequency band may be higher than the first frequency band, and the H-field formed with reference to the second point 602 due to the second feeding signal of the second frequency band being fed to the antenna radiator 330 may be stronger than the H-field formed with reference to the first point 600 due to the first feeding signal of the first frequency band being fed to the antenna radiator 330.

Accordingly, at least one point in a region where the H-field formed with reference to the first point 600 and the H-field formed with reference to the second point 602 are relatively weakly formed on the first ground member 301 may be set as a connection point on the first ground member 301, which is to be connected to the second ground member 302. For example, based on the strength of the H-field formed with reference to the second point 602 which is a strong H-field, at least one point in regions 610 and 612 where the strength of the H-field formed with reference to the second point 602 is relatively small may be set as a connection point on the first ground member 301, which is to be connected to the second ground member 302.

The regions 610 and 612 in FIG. 6 are examples of regions where connection points may be set, and the regions where connection points may be set are not limited to the regions 610 and 612.

FIG. 7 is a view showing an example of a connection point on a first ground member according to an embodiment of the disclosure.

Referring to FIG. 7, connection points 621, 622, 623, and 624 on the first ground member 301 and the second ground member 302 may be set with reference to the H-field formed by the second feeding signal of the second frequency band which is a higher frequency band among the first frequency band and the second frequency band.

For example, points, which are spaced apart by a predetermined distance or more from a second point 602 on the first ground member 301, may be set as the connection points 621, 622, 623, and 624, the second point 602 corresponding to the second feeding point 352 on the antenna radiator 330 to which the second feeding signal of the second frequency band is fed. For example, the connection points 621, 622, 623, and 624 may be set in a region spaced apart from the second point 602 by a distance greater than 1/4 of the wavelength of a reference frequency of the second frequency band. For example, the reference frequency of the second frequency band may be 3 GHz, and points in a region, which is spaced apart from the second point 602 by more than approximately 25 mm which is 1/4 of the wavelength (λ) of 3 GHz, may be set as the connection points 621, 622, 623, and 624.

In the meantime, although FIG. 7 illustrates that four connection points 621, 622, 623, and 624 are set on the first ground member 301, the number and positions of the connection points are not limited thereto. For example, connection points may be variously set in regions on the first ground member 301, in which the intensity of the H-field formed from the first point 600 and the intensity of the H-field formed from the second point 602 are small. For example, connection points may be variously set in regions which are spaced apart from the first point 600 by a distance greater than 1/4 of the wavelength of the reference frequency of the first frequency band and spaced apart from the second point 602 by a distance greater than 1/4 of the wavelength of the reference frequency of the second frequency band. In addition, for example, a line region or a surface region other than a point may also be set as a region on the first ground member 301, to which the second ground member 302 is to be connected.

FIG. 8 is a view showing an example in which a switch is disposed at a connection point on a first ground according to an embodiment of the disclosure.

Referring to FIG. 8, in an embodiment, the connection points 621, 622, 623, and 624 on the first ground member 301 may be connected to the second ground member 302 through switches 631, 632, 633, and 634. For example, the switches 631, 632, 633, and 634 may be arranged on the connection points 621, 622, 623, and 624 on the first ground member 301, and the switches 631, 632, 633, and 634 may be connected to the second ground member 302. For example, the connection points 621, 622, 623, and 624 on the first ground member 301 may be connected to the switches 631, 632, 633, and 634, and the switches 631, 632, 633, and 634 may be connected to the second ground member 302. In an embodiment, the positions and/or the number of the connection points 621, 622, 623, and 624 may be changed based on a frequency band.

According to an embodiment, a wireless communication circuit (e.g., the wireless communication module 192 in FIG. 1) may turn on/off the switches 631, 632, 633, and 634 differently according to the type and the number of feeding signals fed to the antenna radiator 330. According to an embodiment, according to the first frequency band of the first feeding signal and the second frequency band of the second feeding signal, the switches 631, 632, 633, and 634 may be turned on/off differently. For example, according to whether the antenna radiator 330 is fed through single feeding or multiple feeding, the switches 631, 632, 633, and 634 may be selectively turned on/off. For example, according to whether a first feeding signal is fed to the antenna radiator 330, a second feeding signal is fed, or the first feeding signal and the second feeding signal are fed together, the switches 631, 632, 633, and 634 may be selectively turned on/off. In this case, the connection points on the first ground member 301 are not limited to FIG. 7 and FIG. 8 and may be variously set, and based on whether the antenna radiator is fed through single-feeding or multiple feeding and the frequency band of the fed signal, the switches of the connection points may be variously selectively turned on/off.

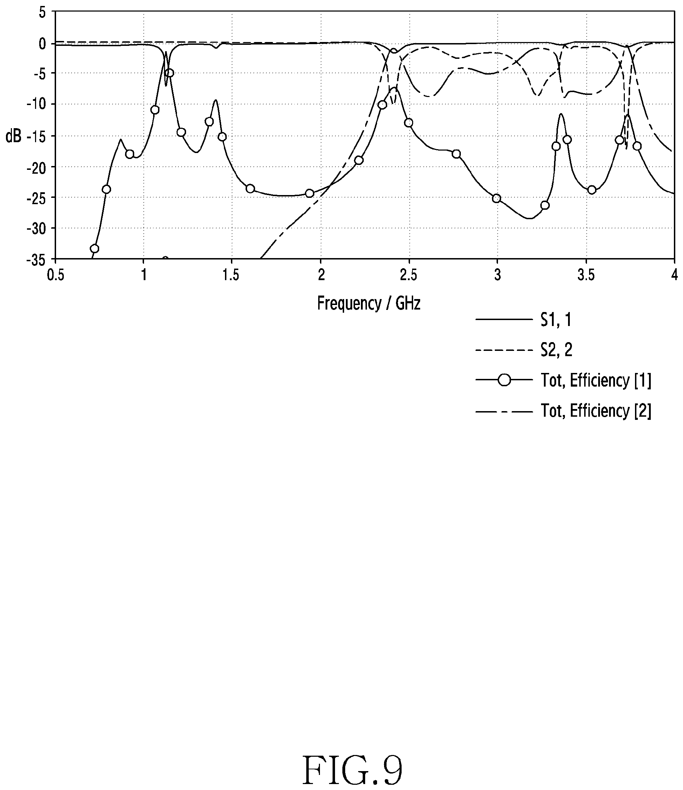

FIG. 9 is a view showing performance of an antenna radiator when a first feeding signal and a second feeding signal are fed to the antenna radiator according to an embodiment of the disclosure.

The graph in FIG. 9 shows S-parameters and radiation efficiencies of the antenna radiator 330 to which a first feeding signal of a first frequency band and a second feeding signal of a second frequency band are fed, when the first feeding signal of the first frequency band of 1 GHz - 1.5 GHz is fed to the first feeding point 351, the second feeding signal of the second frequency band of 3 GHz - 3.5 GHz is fed to the second feeding point, and the connection points 631, 632, 633, and 634 on the first ground member are connected to the second ground member 302, in the electronic device 101 in FIG. 1 to FIG. 8.

Referring to FIG. 9, when the first feeding signal of the first frequency band of 1 GHz - 1.5 GHz is fed to a first feeding point 351 and the second feeding signal of the second frequency band of 3 GHz - 3.5 GHz is fed to a second feeding point, interference between the first feeding signal of the first frequency band and the second feeding signal of the second frequency band may be reduced, so that all of the signal radiation characteristics in the first frequency band and the second frequency band can be effectively maintained. Accordingly, the antenna radiator 330, to which the first feeding signal and the second feeding signal are fed, can effectively radiate the signal of the first frequency band and the signal of the second frequency band.

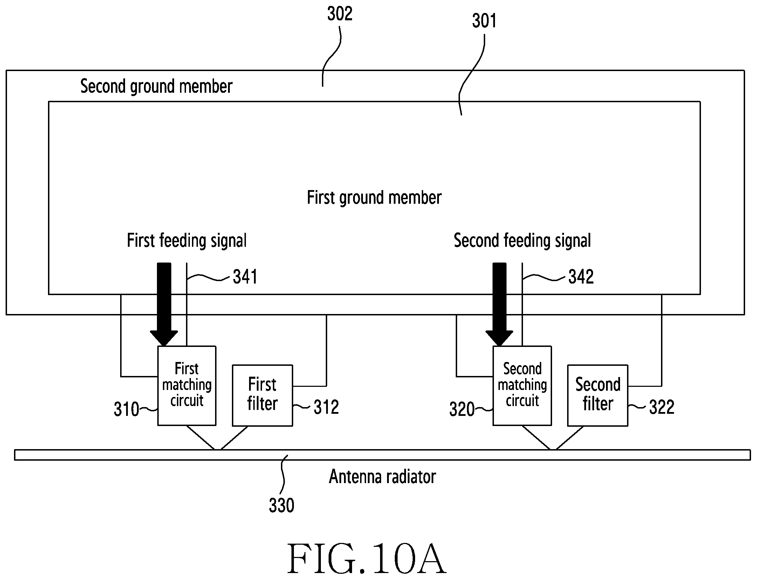

FIG. 10A is a view showing an example in which a first matching circuit, a first filter, a second matching circuit, and a second filter are connected to a first ground member and a second ground member according to an embodiment.

Referring to FIG. 10A, the first matching circuit 310 may be grounded to the first ground member 301, and the first filter 312 may be grounded to the second ground member 302. In addition, the second matching circuit 320 may be grounded to the second ground member 302, and the second filter 322 may be grounded to the first ground member 301.

According to an embodiment, the first feeding signal fed to the antenna radiator 330 may flow to the first ground member 301 via the antenna radiator 330 and the second filter 322, and the second feeding signal fed to the antenna radiator 330 may flow to the second ground member 302 via the antenna radiator 330 and the first filter 312.

In this case, as the first matching circuit 310 and the first filter 312 are respectively grounded to different ground members, when the first feeding signal and the second feeding signal are fed to the antenna radiator 330 through multiple feeding, the occurrence of interference between the first matching circuit 310 and the first filter 312 adjacent to each other may be reduced. In addition, as the second matching circuit 320 and the second filter 322 are respectively grounded to different ground members, when the first feeding signal and the second feeding signal are fed to the antenna radiator 330 through multiple feeding, the occurrence of interference between the second matching circuit 320 and the second filter 322 adjacent to each other may be reduced.

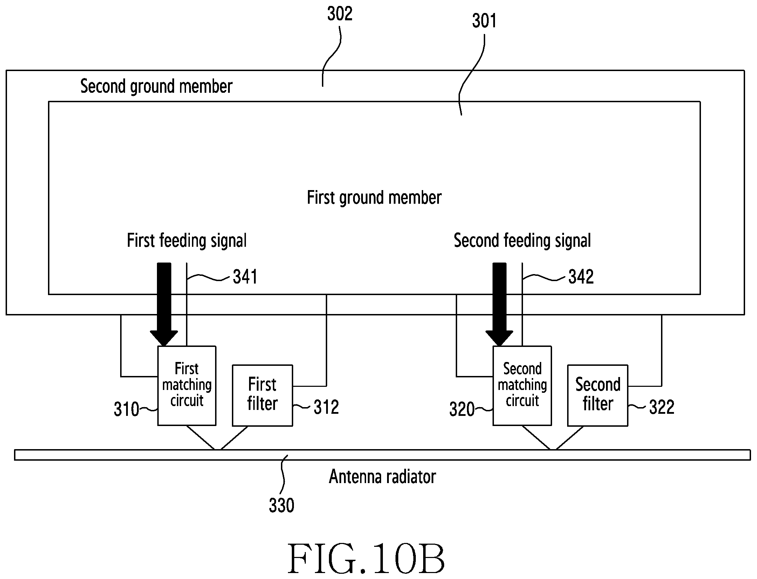

FIG. 10B is a view showing an example in which a first matching circuit, a first filter, a second matching circuit, and a second filter are connected to a first ground member and a second ground member according to an embodiment.

Referring to FIG. 10A, the first matching circuit 310 may be grounded to the second ground member 302, and the first filter 312 may be grounded to the first ground member 301. In addition, the second matching circuit 320 may be grounded to the first ground member 301, and the second filter 322 may be grounded to the second ground member 302.

According to an embodiment, the first feeding signal fed to the antenna radiator 330 may flow to the second ground member 302 via the antenna radiator 330 and the second filter 322, and the second feeding signal fed to the antenna radiator 330 may flow to the first ground member 301 via the antenna radiator 330 and the first filter 312.

In this case, as the first matching circuit 310 and the first filter 312 are respectively grounded to different ground members, when the first feeding signal and the second feeding signal are fed to the antenna radiator 330 through multiple feeding, the occurrence of interference between the first matching circuit 310 and the first filter 312 adjacent to each other may be reduced. In addition, as the second matching circuit 320 and the second filter 322 are respectively grounded to different ground members, when the first feeding signal and the second feeding signal are fed to the antenna radiator 330 through multiple feeding, the occurrence of interference between the second matching circuit 320 and the second filter 322 adjacent to each other may be reduced.

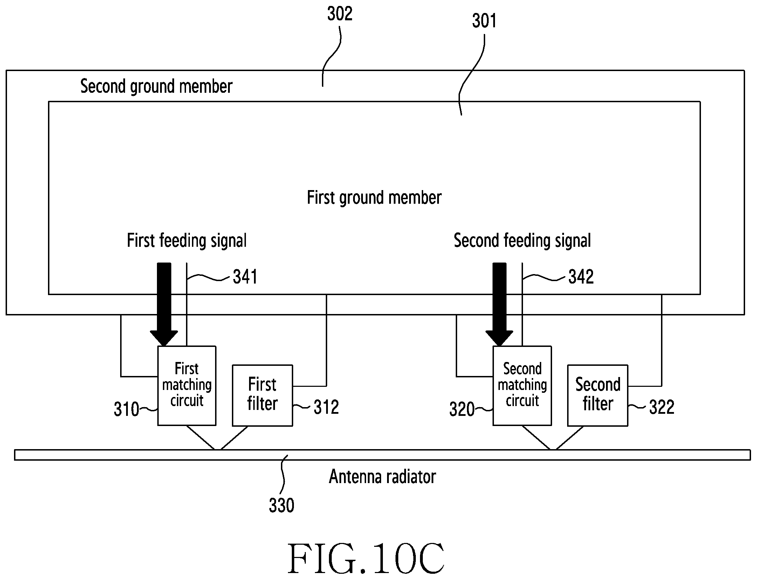

FIG. 10C is a view showing an example in which a first matching circuit, a first filter, a second matching circuit, and a second filter are connected to a first ground member and a second ground member according to an embodiment.

Referring to FIG. 10C, the first matching circuit 310 may be grounded to the second ground member 302, and the first filter 312 may be grounded to the first ground member 301. In addition, the second matching circuit 320 may be grounded to the second ground member 302, and the second filter 322 may be grounded to the first ground member 301.

According to an embodiment, the first feeding signal fed to the antenna radiator 330 may flow to the first ground member 301 via the antenna radiator 330 and the second filter 322, and the second feeding signal fed to the antenna radiator 330 may flow to the first ground member 301 via the antenna radiator 330 and the first filter 312.

In this case, as the first matching circuit 310 and the first filter 312 are respectively grounded to different ground members, when the first feeding signal and the second feeding signal are fed to the antenna radiator 330 through multiple feeding, the occurrence of interference between the first matching circuit 310 and the first filter 312 adjacent to each other may be reduced. In addition, as the second matching circuit 320 and the second filter 322 are respectively grounded to different ground members, when the first feeding signal and the second feeding signal are fed to the antenna radiator 330 through multiple feeding, the occurrence of interference between the second matching circuit 320 and the second filter 322 adjacent to each other may be reduced.

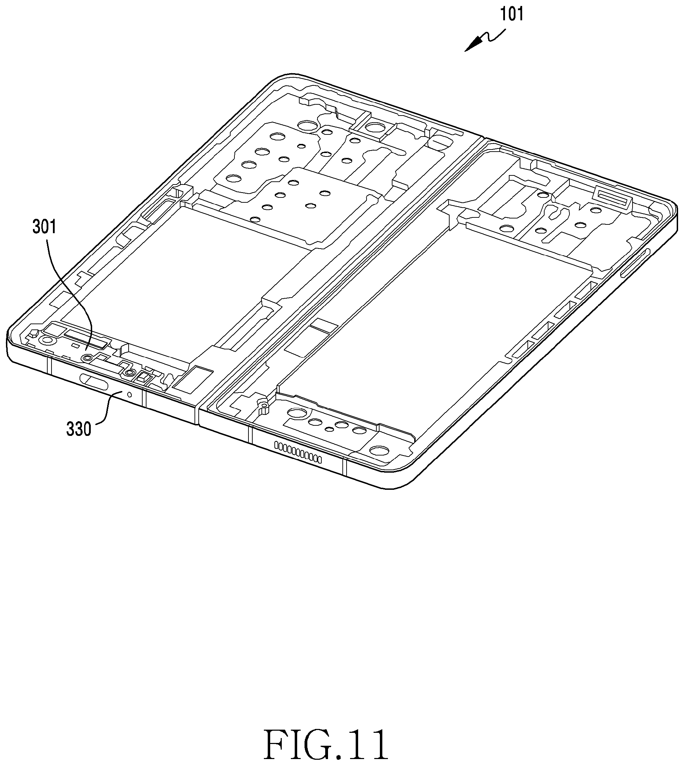

FIG. 11 is a view showing an example in which a ground member and an antenna radiator, to which a first feeding signal and a second feeding signal are fed, are arranged, in an electronic device according to an embodiment.

Referring to FIG. 11, the antenna radiator 330 may be formed on a side member positioned at a lower end portion of the electronic device 101, and the first ground member 301 may be disposed at a position adjacent to the antenna radiator 330.

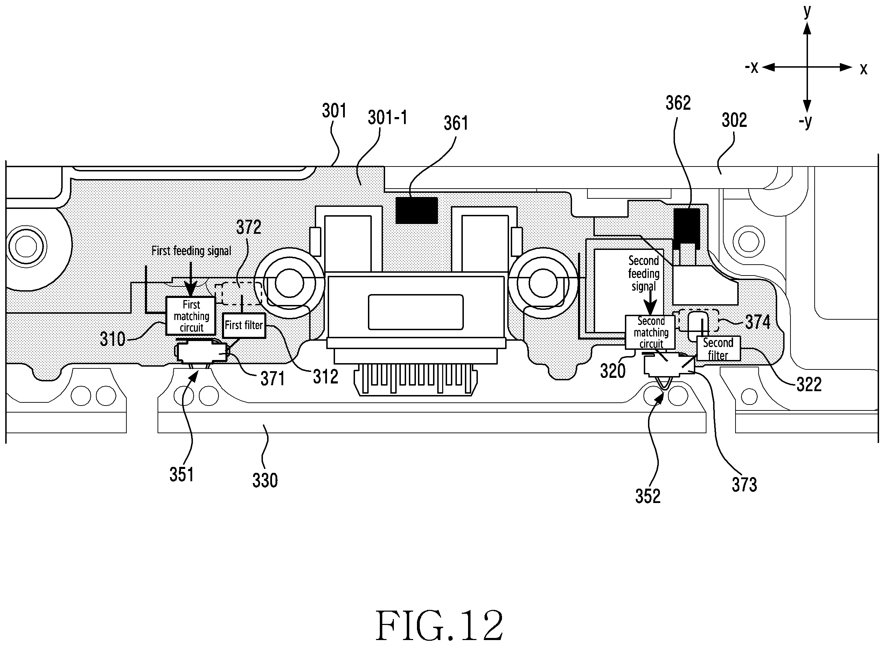

The arrangement of the first ground member 301, the second ground member 302, the first matching circuit 310, the first filter 312, the second matching circuit 320, and the second filter 322 in the electronic device 101 will be described in more detail with reference to FIG. 12 to FIG. 17.

FIG. 12 is a view showing an example in which a first matching circuit, a first filter, a second matching circuit, a second filter, a first ground member, a second ground member, and an antenna radiator are arranged when an electronic device is viewed from the front side of the electronic device according to an embodiment.

Referring to FIG. 12, when the electronic device is viewed in the -z-axis direction in FIG. 2A, the first ground member 301 and the second ground member 302 may be arranged to be laminated on each other. For example, the first ground member 301 may include a PCB, and the second ground member 302 may include a support member (e.g., a front metal) which supports components in the electronic device 101. For example, the first ground member 301 may include a ground member formed in the PCB.

According to an embodiment, the first matching circuit 310, the first filter 312, and a connection member 371 may be arranged on the PCB. For example, the first matching circuit 310 and the first filter 312 may be arranged on the PCB to be electrically connected to the first feeding point 351 of the antenna radiator 330 through the connection member 371. However, the arrangement positions of the first matching circuit 310, the first filter 312, and the connection member 371 are not limited thereto.

According to an embodiment, the first matching circuit 310 may be grounded to a ground region 301-1 of the first ground member 301. For example, the first ground member 301 may include a PCB having a laminated structure in which a dielectric layer and a metal plating layer are alternately and repeatedly laminated, and the ground region 301-1 may be a region (e.g., the plating layer) other than the fill cut region in which a part of the plating layer in the PCB is removed. For example, the first filter 312 may be grounded to the second ground member 302 through a connection member 372 positioned between the first ground member 301 and the second ground member 302.

According to an embodiment, the second matching circuit 320, the second filter 322, and a connection member 373 may be arranged on the PCB. For example, the second matching circuit 320 and the second filter 322 may be arranged on the PCB to be electrically connected to the first feeding point 352 of the antenna radiator 330 through the connection member 373. The arrangement positions of the second matching circuit 320, the second filter 322, and the connection member 373 are not limited thereto.

According to an embodiment, the second matching circuit 320 may be grounded to the ground region 301-1 of the first ground member 301. For example, the first ground member 301 may include a PCB having a laminated structure in which a dielectric layer and a metal plating layer are alternately and repeatedly laminated, and the ground region 301-1 may be a region (e.g., the plating layer) other than the fill cut region in which a part of the plating layer in the ground member 301 is removed. For example, the second filter 322 may be grounded to the second ground member 302 through a connection member 374 positioned between the first ground member 301 and the second ground member 302.

According to an embodiment, the first ground member 301 and the second ground member 302 may be connected to each other through a connection member 361 and/or a connection member 362 disposed between the first ground member 301 and the second ground member 302. For example, the position where the connection member 361 and/or the connection member 362 is disposed may be set based on at least one of the first frequency band of the first feeding signal, the second frequency band of the second feeding signal, the position of the first feeding point 351, the position of the second feeding point 352, the positions of electronic elements on the first ground member 301, or the region of the first ground member 301, which overlaps the second ground member 302.

For example, the connection member 371, 372, 373, 374, 361, or 362 may include a C-clip, a surface mounted device (SMD) gasket, a flexible printed circuit board (FPCB), a spring, a plate spring, a conductive sponge, a screw, or a spring washer, but is not limited thereto.

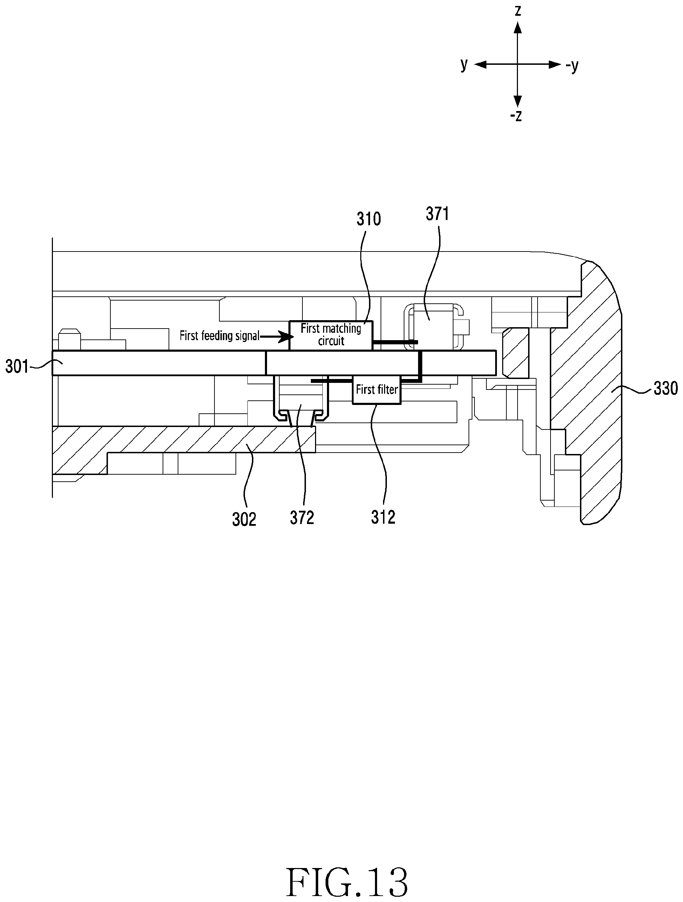

FIG. 13 is a view showing an example in which a first matching circuit, a first filter, a first ground member, a second ground member, and an antenna radiator are arranged when an electronic device is viewed from the side surface of the electronic device according to an embodiment.

Referring to FIG. 13, when the electronic device is viewed in the x-axis direction in FIG. 2A, the second ground member 302 may be disposed below (e.g., in the -z-axis direction) the first ground member 301. For example, the first ground member 301 may include at least a part of a PCB, and the second ground member 302 may include a support member (e.g., a front metal) which supports components in the electronic device 101. For example, the first ground member 301 may include a ground member formed in the PCB.

According to an embodiment, the first matching circuit 310 and the connection member 371 may be arranged on the upper surface (e.g., in the +z-axis direction) of the PCB, and the first filter 312 and the connection member 372 may be arranged on the lower surface (e.g., in the -z-axis direction) of the PCB. The first matching circuit 310 and the first filter 312 may be connected to the antenna radiator 330 through the connection member 371, and the first matching circuit 310 may be grounded to the first ground member 301.

According to an embodiment, the first filter 312 may be connected to the connection member 372, the connection member 372 may be disposed between the first ground member 301 and the second ground member 302, and thus the first filter 312 may be grounded to the second ground member 302 through the connection member 372.

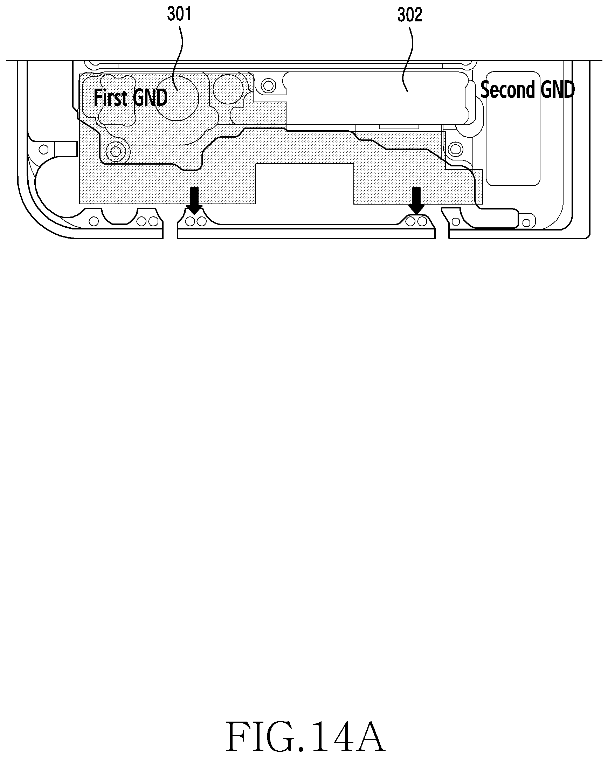

FIG. 14A to FIG. 14F are views showing examples of a first ground member and a second ground member according to various embodiments.

Referring to FIG. 14A, for example, the first ground member 301 may include at least a part of a PCB, and the second ground member 302 may include a support member (e.g., a front metal) which supports electronic components in the electronic device 101.

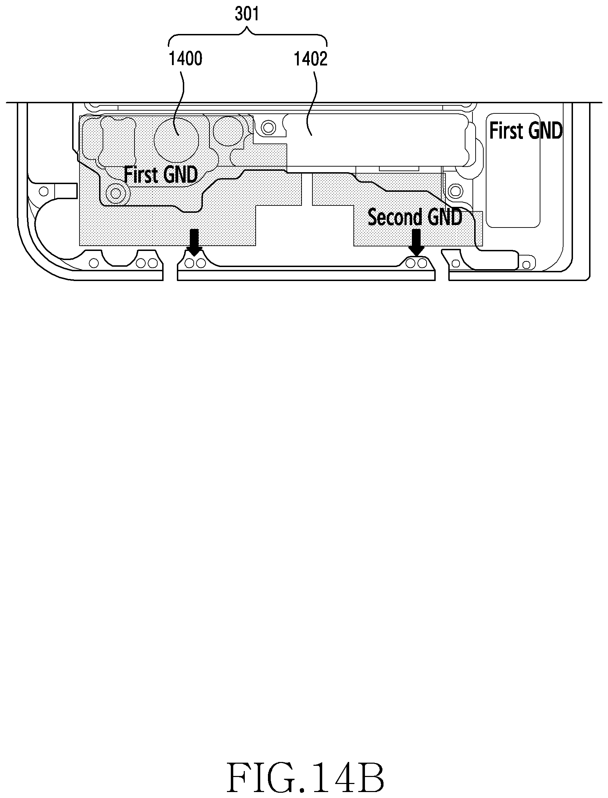

Referring to FIG. 14B, for example, the first ground member 301 may be a member including at least a part of a PCB 1400 and a support member 1402 (e.g., a front metal) which supports electronic components in the electronic device 101, and the second ground member 302 may include at least a part of a separate PCB which is separated from the first ground member 301. In this case, for example, the first ground member 301 may include a ground region formed in the PCB 1400 and the support member 1402 (e.g., a front metal) which supports electronic components in the electronic device 101.

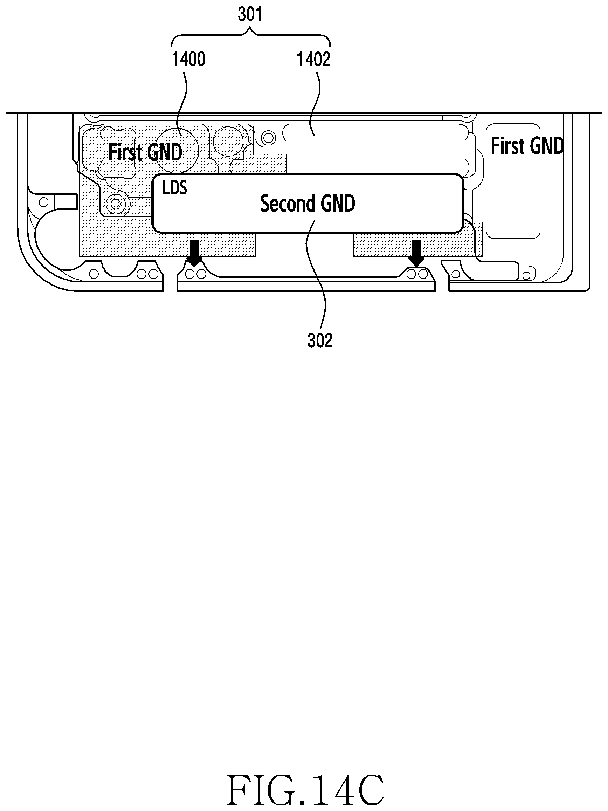

Referring to FIG. 14C, for example, the first ground member 301 may be a member including at least a part of a PCB 1400 and a support member 1402 (e.g., a front metal) which supports electronic components in the electronic device 101, and the second ground member 302 may be a laser direct structuring (LDS)-based member. In this case, for example, the first ground member 301 may include a ground region formed in the PCB 1400 and the support member 1402 (e.g., a front metal) which supports electronic components in the electronic device 101.

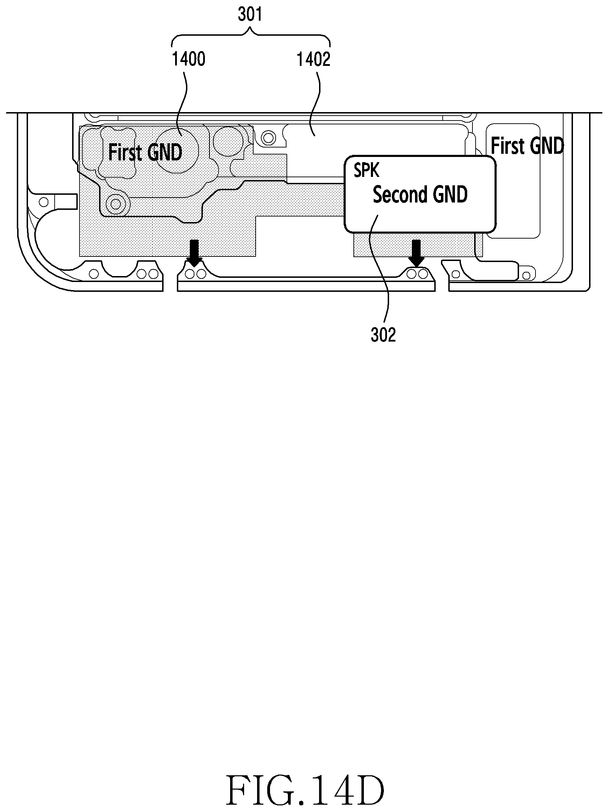

Referring to FIG. 14D, for example, the first ground member 301 may be a member including at least a part of a PCB 1400 and a support member 1402 (e.g., a front metal) which supports electronic components in the electronic device 101, and the second ground member 302 may be a speaker device. In this case, for example, the first ground member 301 may include a ground region formed in the PCB 1400 and the support member 1402 (e.g., a front metal) which supports electronic components in the electronic device 101.

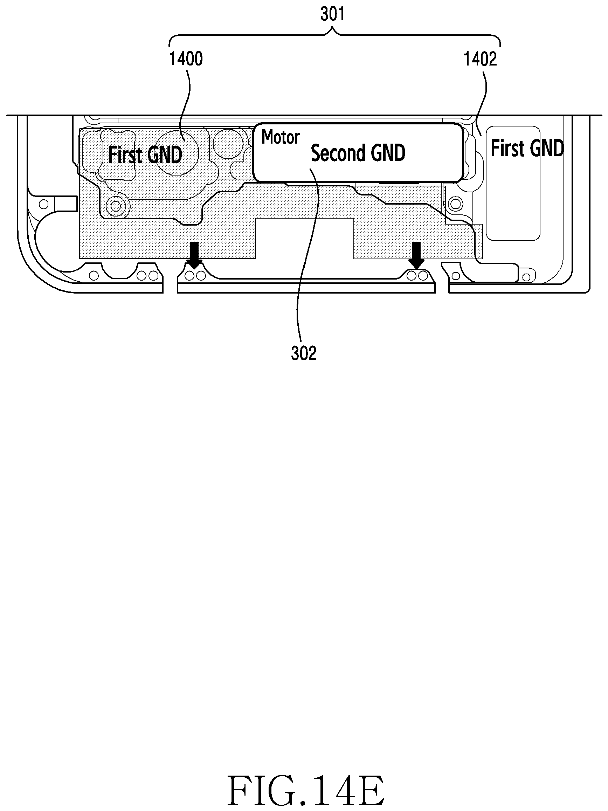

Referring to FIG. 14E, for example, the first ground member 301 may be a member including at least a part of a PCB 1400 and a support member 1402 (e.g., a front metal) which supports electronic components in the electronic device 101, and the second ground member 302 may be a motor device. In this case, for example, the first ground member 301 may include a ground region formed in the PCB 1400 and the support member 1402 (e.g., a front metal) which supports electronic components in the electronic device 101.

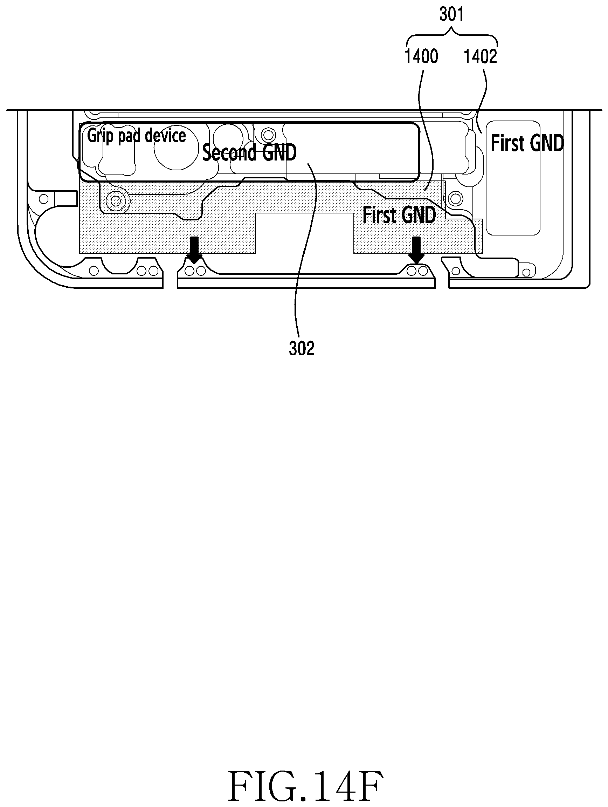

Referring to FIG. 14F, for example, the first ground member 301 may be a member including a PCB 1400 and a support member 1402 (e.g., a front metal) which supports electronic components in the electronic device 101, and the second ground member 302 may be a grip pad device.

As illustrated in FIG. 14A to FIG. 14F, various types and sizes of ground members may be used for multiple feeding of the disclosure. According to an embodiment, the smaller the size of at least one of the first ground member 301 and the second ground member 302 is, the better the antenna radiation performance may be since a feeding signal of a higher frequency band is grounded for multiple feeding. Accordingly, for example, the size of the first ground member 301, the size of the second ground member 302, and the connection point between the first ground member 301 and the second ground member 302 may be differently set according to the frequency bands of feeding signals fed through multiple feeding. Alternatively, for example, the frequency bands of feeding signals fed through multiple feeding may be differently set according to the size of the first ground member 301, the size of the second ground member 302, and the connection point between the first ground member 301 and the second ground member 302 which are to be used in the electronic device 101.

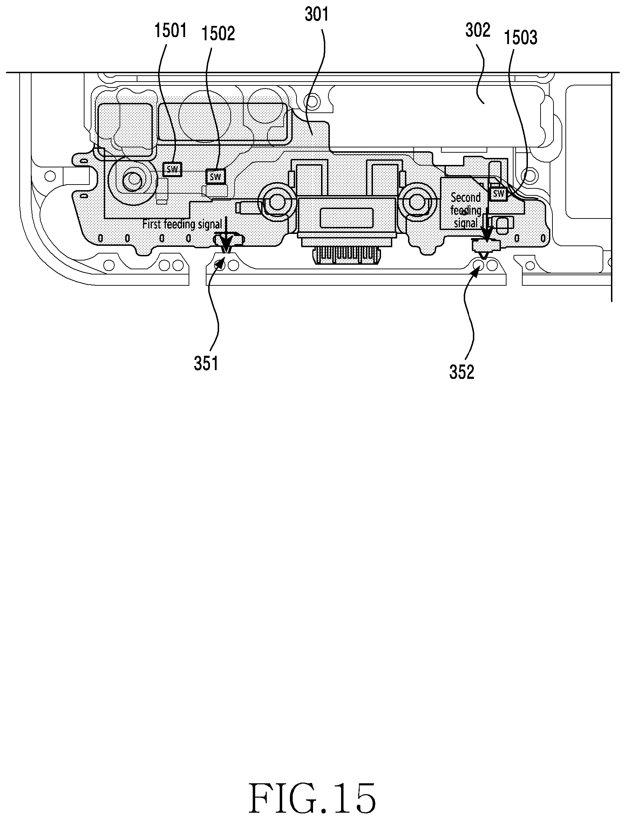

FIG. 15 is a view showing an example of a switch disposed at a connection point of a first ground member, to which a second ground member is connected, when an electronic device is viewed from the front side of the electronic device according to an embodiment.

Referring to FIG. 15, in an embodiment, the first ground member 301 may be a PCB, and the second ground member 302 may be a support member (e.g., a front metal) which supports electronic components in the electronic device 101. In addition, a first switch 1501, a second switch 1502, and a third switch 1503 may be arranged between the first ground member 301 and the second ground member 302. The first ground member 301 and the second ground member 302 may be selectively connected through at least one of the first switch 1501, the second switch 1502, or the third switch 1503.

According to an embodiment, the positions, at which the first switch 1501, the second switch 1502, and the third switch 1503 are arranged in the first ground member 301, may be determined based on at least one of the strength of an H-field formed with reference to the first feeding point 351 or the strength of an H-field formed with reference to the second feeding point 352. For example, the positions, at which the first switch 1501, the second switch 1502, and the third switch 1503 are arranged in the first ground member 301, may be determined based on at least one of the wavelength of a reference frequency of the first frequency band of the first feeding signal or the wavelength of a reference frequency of the second frequency band of the second feeding signal. For example, the first switch 1501, the second switch 1502, and the third switch 1503 may be arranged in at least one of regions which are farther from the first feeding point 351 than 1/4 of the wavelength of the reference frequency of the first frequency band of the first feeding signal or farther from the second feeding point 352 than 1/4 of the wavelength of the reference frequency of the second frequency band of the second feeding signal.

According to an embodiment, based on at least one of a type of feeding for the antenna radiator 330, a frequency band of the first feeding signal, or a frequency band of the second feeding signal, the ON/OFF of the first switch 1501, the second switch 1502, and the third switch 1503 may be controlled. For example, according to whether the feeding for the antenna radiator 330 is a single feeding (e.g., the first feeding signal or the second feeding signal is fed to the antenna radiator 330) or a multiple feeding (e.g., the first feeding signal and the second feeding signal are fed to the antenna radiator 330 together), the ON/OFF of the first switch 1501, the second switch 1502, and the third switch 1503 may be selectively controlled. In addition, for example, according to a combination of frequency bands of the feeding signals fed to the antenna radiator 330, the ON/OFF of the first switch 1501, the second switch 1502, and the third switch 1503 may be selectively controlled.

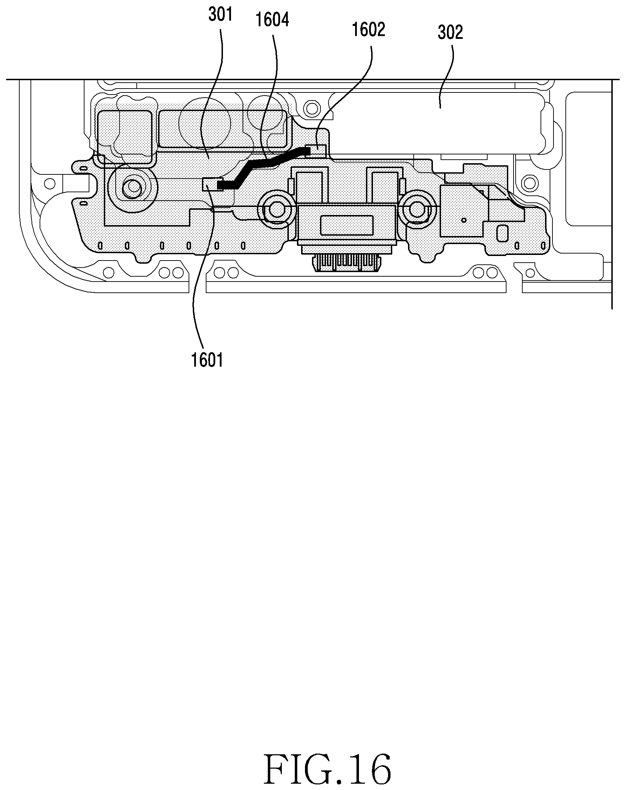

FIG. 16 is a view showing an example in which a first ground member and a second ground member are connected to each other through an FPCB according to an embodiment.

Referring to FIG. 16, a first connection point 1601 of the first ground member 301 and a second connection point 1602 of the second ground member 302 may be connected to each other through an FPCB 1604 disposed between the first ground member 301 and the second ground member 302. For example, when a space, in which a connection member (e.g., a C-clip, a spring, a plate spring, a conductive sponge, a screw, or a spring washer) for connecting the first ground member 301 and the second ground member 302 is to be disposed, is insufficient, the first connection point 1601 may be connected to the second connection point 1602 through the FPCB 1604. In addition, for example, when the electronic device 101 is viewed in the -z-axis direction in FIG. 2A, the first connection point 1601 of the first ground member 301 may not overlap the second connection point 1602 of the second ground member 302. In this case, for example, the first connection point 1601 of the first ground member 301 may be one of the connection points set in FIG. 7, but is not limited thereto.

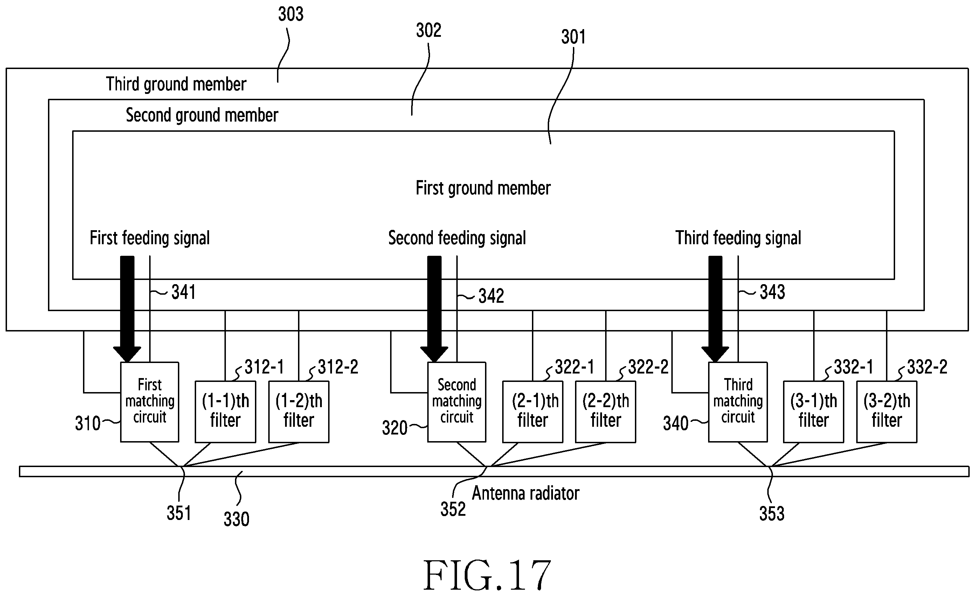

FIG. 17 is a view showing an example in which three feeding signals are provided to an antenna radiator according to an embodiment.

Referring to FIG. 17, the electronic device 101 according to an embodiment may include a first ground member 301, a second ground member 302, a third ground member 303, a first matching circuit 310, a (1-1)th filter 312-1, a (1-2)th filter 312-2, a second matching circuit 320, a (2-1)th filter 322-1, a (2-2)th filter 322-2, a third matching circuit 340, a (3-1)th filter 332-1, a (3-2)th filter 332-2, and/or an antenna radiator 330.

According to an embodiment, the first ground member 301 may be a ground member connected to at least one of the first matching circuit 310, the (1-1)th filter 312-1, the (1-2)th filter 312-2, the second matching circuit 320, the (2-1)th filter 322-1, the (2-2)th filter 322-2, the third matching circuit 340, the (3-1)th filter 332-1, or the (3-2)th filter 332-2. The first ground member 301 may include at least a part of components in the electronic device 101. For example, the first ground member 301 may include at least one of a printed circuit board (PCB), a support member (e.g., a front metal), a laser direct structuring (LDS)-based member, a speaker device, a motor device, or a grip pad, but is not limited thereto.

According to an embodiment, the second ground member 302 may be a ground member connected to at least one of the first matching circuit 310, the (1-1)th filter 312-1, the (1-2)th filter 312-2, the second matching circuit 320, the (2-1)th filter 322-1, the (2-2)th filter 322-2, the third matching circuit 340, the (3-1)th filter 332-1, or the (3-2)th filter 332-2. The second ground member 302 may include at least a part of components in the electronic device 101. For example, the second ground member 302 may include at least one of a printed circuit board (PCB), a support member (e.g., a front metal), a laser direct structuring (LDS)-based member, a speaker device, a motor device, or a grip pad, but is not limited thereto.

According to an embodiment, the third ground member 303 may be a ground member connected to at least one of the first matching circuit 310, the (1-1)th filter 312-1, the (1-2)th filter 312-2, the second matching circuit 320, the (2-1)th filter 322-1, the (2-2)th filter 322-2, the third matching circuit 340, the (3-1)th filter 332-1, or the (3-2)th filter 332-2. The third ground member 303 may include at least a part of components in the electronic device 101. For example, the third ground member 303 may include at least one of a printed circuit board (PCB), a support member (e.g., a front metal), a laser direct structuring (LDS)-based member, a speaker device, a motor device, or a grip pad, but is not limited thereto.

According to an embodiment, the first matching circuit 310, the (1-1)th filter 312-1, and the (1-2)th filter 312-2 may be respectively connected to different ground members among the first ground member 301, the second ground member 302, and the third ground member 303. The second matching circuit 320, the (2-1)th filter 322-1, and the (2-2)th filter 322-2 may be respectively connected to different ground members among the first ground member 301, the second ground member 302, and the third ground member 303. The third matching circuit 340, the (3-1)th filter 332-1, and the (3-2)th filter 332-2 may be respectively connected to different ground members among the first ground member 301, the second ground member 302, and the third ground member 303.

According to an embodiment, at least a part of the first ground member 301 may be disposed to overlap the second ground member 302 and the third ground member 303. For example, when viewed in the -z-axis direction in FIG. 2A, at least a part of the first ground member 301 may be disposed to overlap or be laminated with the second ground member 302 and the third ground member 303. The first ground member 301, the second ground member 302, and the third ground member 303 may be electrically connected to each other through one or more connection points.

According to an embodiment, the first matching circuit 310 may be disposed to adjust a length of an electrical path of the antenna radiator 330 which radiates the first feeding signal of the first frequency band. The first matching circuit 310 may be disposed on the feeding line 341 which transmits the first feeding signal from a wireless communication circuit (e.g., the wireless communication module 192 in FIG. 1) to the antenna radiator 330, and the first matching circuit 310 may be grounded to the first ground member 301. For example, the first matching circuit 310 may be disposed near the first feeding point 351 on the feeding line 341 from the wireless communication circuit to the first feeding point 351.

According to an embodiment, the first ground member 301 may be a PCB, and the first matching circuit 310 may be disposed at a position adjacent to the first feeding point 351 on the first ground member 301 and be grounded to the first ground member 301. Alternatively, the first matching circuit 310 may be disposed on another PCB other than the first ground member 301. When the first ground member 301 is a PCB, the wireless communication circuit may be disposed on the first ground member 301 or be disposed on another PCB. The first matching circuit 310 may include at least one capacitance and/or at least one inductance. For example, the first frequency band may be a frequency band for GPS communication, a frequency band for Bluetooth communication, or a frequency band for 5G communication, but is not limited thereto. In addition, for example, the first frequency band may be 824 - 960 MHz frequency band or 1710 - 2170 MHz frequency band, but is not limited thereto. In addition, for example, the first frequency band, the second frequency band, and the third frequency band may not overlap each other, and each of the gaps between the first frequency band, the second frequency band, and the third frequency band may be greater than at least 800 MHz.

According to an embodiment, the (1-1)th filter 312-1 and the (1-2)th filter 312-2 may be arranged in order to remove frequency interference from feeding signals other than the first feeding signal. For example, the (1-1)th filter 312-1 may be disposed in order to remove frequency interference from the second feeding signal other than the first feeding signal, and the (1-2)th filter 312-2 may be disposed in order to remove frequency interference from the third feeding signal other than the first feeding signal. The (1-1)th filter 312-1 may be grounded to the second ground member 302 other than the first ground member 301, and the (1-2)th filter 312-2 may be grounded to the third ground member 303. For example, the first ground member 301 may be a PCB, and the (1-1)th filter 312-1 and the (1-2)th filter 312-2 may be arranged at positions adjacent to the first feeding point 351 on the first ground member 301.

According to an embodiment, the (1-1)th filter 312-1 may be formed to allow the second feeding signal of the second frequency band to pass through to the second ground member 302. The second feeding signal may be a signal of the second frequency band, and the second feeding signal flowing through the antenna radiator 330 may pass through to the second ground member 302 through the (1-1)th filter 312-1.

According to an embodiment, the (1-2)th filter 312-2 may be formed to allow the third feeding signal of the third frequency band to pass through to the second ground member 303. The third feeding signal may be a signal of the third frequency band, and the third feeding signal flowing through the antenna radiator 330 may pass through to the third ground member 303 through the (1-2)th filter 312-2.

According to an embodiment, the second matching circuit 320 may be disposed to adjust a length of an electrical path of the antenna radiator 330 which radiates the second feeding signal of the second frequency band. The second matching circuit 320 may be disposed on the feeding line 342 which transmits the second feeding signal from a wireless communication circuit (e.g., the wireless communication module 192 in FIG. 1) to the antenna radiator 330, and the second matching circuit 320 may be grounded to the first ground member 301. For example, the second matching circuit 320 may be disposed near the second feeding point 352 on the feeding line 342 from the wireless communication circuit to the second feeding point 352.

According to an embodiment, the first ground member 301 may be a PCB, and the second matching circuit 320 may be disposed at a position adjacent to the second feeding point 352 on the first ground member 301 and be grounded to the first ground member 301. Alternatively, the second matching circuit 320 may be disposed on another PCB other than the first ground member 301. When the first ground member 301 is a PCB, the wireless communication circuit may be disposed on the first ground member 301 or be disposed on another PCB. The second matching circuit 320 may include at least one capacitance and/or at least one inductance. For example, the second frequency band may be a frequency band for GPS communication, a frequency band for Bluetooth communication, or a frequency band for 5G communication, but is not limited thereto. In addition, for example, the second frequency band may be 824 - 960 MHz frequency band or 1710 - 2170 MHz frequency band, but is not limited thereto. In addition, for example, the first frequency band, the second frequency band, and the third frequency band may not overlap each other, and each of the gaps between the first frequency band, the second frequency band, and the third frequency band may be greater than at least 800 MHz.

According to an embodiment, the (2-1)th filter 322-1 and the (2-2)th filter 322-2 may be arranged in order to remove frequency interference from feeding signals other than the second feeding signal. For example, the (2-1)th filter 322-1 may be disposed in order to remove frequency interference from the first feeding signal other than the second feeding signal, and the (2-2)th filter 322-2 may be disposed in order to remove frequency interference from the third feeding signal other than the second feeding signal. The (2-1)th filter 322-1 may be grounded to the second ground member 302 other than the first ground member 301, and the (2-2)th filter 322-2 may be grounded to the third ground member 303. For example, the first ground member 301 may be a PCB, and the (2-1)th filter 322-1 and the (2-2)th filter 322-2 may be arranged at positions adjacent to the second feeding point 352 on the first ground member 301.

According to an embodiment, the (2-1)th filter 322-1 may be formed to allow the first feeding signal of the first frequency band to pass through to the second ground member 302. The first feeding signal may be a signal of the first frequency band, and the first feeding signal flowing through the antenna radiator 330 may pass through to the second ground member 302 through the (2-1)th filter 322-1.

According to an embodiment, the (2-2)th filter 322-2 may be formed to allow the third feeding signal of the third frequency band to pass through to the second ground member 303. The third feeding signal may be a signal of the third frequency band, and the third feeding signal flowing through the antenna radiator 330 may pass through to the third ground member 303 through the (2-2)th filter 322-2.

According to an embodiment, the third matching circuit 340 may be disposed to adjust a length of an electrical path of the antenna radiator 330 which radiates the third feeding signal of the third frequency band. The third matching circuit 340 may be disposed on a feeding line 343 which transmits the third feeding signal from a wireless communication circuit (e.g., the wireless communication module 192 in FIG. 3) to the antenna radiator 330, and the third matching circuit 340 may be grounded to the first ground member 301. For example, the third matching circuit 340 may be disposed near a third feeding point 353 on the feeding line 343 from the wireless communication circuit to the third feeding point 353.

According to an embodiment, the first ground member 301 may be a PCB, and the third matching circuit 340 may be disposed at a position adjacent to the third feeding point 353 on the first ground member 301 and be grounded to the first ground member 301. Alternatively, the third matching circuit 340 may be disposed on another PCB other than the first ground member 301. When the first ground member 301 is a PCB, the wireless communication circuit may be disposed on the first ground member 301 or be disposed on another PCB. The third matching circuit 340 may include at least one capacitance and/or at least one inductance. For example, the third frequency band may be a frequency band for GPS communication, a frequency band for Bluetooth communication, or a frequency band for 5G communication, but is not limited thereto. In addition, for example, the second frequency band may be 824 - 960 MHz frequency band or 1710 - 2170 MHz frequency band, but is not limited thereto. In addition, for example, the first frequency band, the second frequency band, and the third frequency band may not overlap each other, and each of the gaps between the first frequency band, the second frequency band, and the third frequency band may be greater than at least 800 MHz.

According to an embodiment, the (3-1)th filter 332-1 and the (3-2)th filter 332-2 may be arranged in order to remove frequency interference from feeding signals other than the third feeding signal. For example, the (3-1)th filter 332-1 may be disposed in order to remove frequency interference from the first feeding signal other than the third feeding signal, and the (3-2)th filter 332-2 may be disposed in order to remove frequency interference from the first feeding signal other than the third feeding signal. The (3-1)th filter 332-1 may be grounded to the second ground member 302 other than the first ground member 301, and the (3-2)th filter 332-2 may be grounded to the third ground member 303. For example, the first ground member 301 may be a PCB, and the (3-1)th filter 332-1 and the (3-2)th filter 332-2 may be arranged at positions adjacent to the third feeding point 353 on the first ground member 301.

According to an embodiment, the (3-1)th filter 332-1 may be formed to allow the first feeding signal of the first frequency band to pass through to the second ground member 302. The first feeding signal may be a signal of the first frequency band, and the first feeding signal flowing through the antenna radiator 330 may pass through to the second ground member 302 through the (3-1)th filter 332-1.

According to an embodiment, the (3-2)th filter 332-2 may be formed to allow the second feeding signal of the second frequency band to pass through to the third ground member 303. The second feeding signal may be a signal of the second frequency band, and the first feeding signal flowing through the antenna radiator 330 may pass through to the third ground member 303 through the (3-2)th filter 332-2.

According to an embodiment, at least a part of the side member 218 in FIG. 2A may be used as the antenna radiator 330. For example, the antenna radiator may correspond to the conductive portion 2181 of the side member 218 in FIG. 2A, but is not limited thereto. The antenna radiator 330 may be another conductive portion included in the side member 218 in FIG. 2A.

In the above description, the first ground member 301, the second ground member 302, and the third ground member 302 are described as separate members connected to each other, but are not limited thereto. At least two of the first ground member 301, the second ground member 302, and the third ground member 303 may also be formed to be distinguished from each other in a single member.

According to an embodiment, an electronic device 101 may include: a housing 210 including a front plate 202 facing a front side of the electronic device, a rear plate 211 facing a rear side of the electronic device, and a side member 218 disposed between the front plate and the rear plate, the side member including a conductive portion operating as an antenna radiator; at least one wireless communication circuit 192 electrically connected to the conductive portion and configured to provide a signal of a designated frequency band; a first ground member 301 disposed in the housing; a second ground member 302 disposed in the housing so as to at least partially overlap the first ground member; a first matching circuit 310 which is disposed on a first feeding line configured to transmit a first feeding signal of a first frequency band provided from the at least one wireless communication circuit to a first feeding point on the conductive portion, and is grounded to the first ground member; a first filter 312 connected to the first feeding point and grounded to the second ground member; a second matching circuit 320 which is disposed on a second feeding line configured to transmit a second feeding signal of a second frequency band provided from the at least one wireless communication circuit to a second feeding point on the conductive portion, and is grounded to the first ground member; and a second filter 322 connected to the second feeding point and grounded to the second ground member.

In addition, the second ground member may be electrically connected to at least one connection point of the first ground member.

In addition, the first frequency band may be higher than the second frequency band, and the distance from the first feeding point to the at least one connection point may be determined based on a wavelength of the first frequency band which is higher than the second frequency band.

In addition, the distance from the first feeding point to the at least one connection point may be longer than 1/4 of a wavelength of the first frequency band.

In addition, the at least one connection point of the first ground member may be connected to the second ground member through at least one switch.

In addition, an operation of the at least one switch may be controlled according to at least one frequency band of the first feeding signal or the second feeding signal which is fed from the at least one wireless communication circuit to the conductive portion.

In addition, the at least one connection point of the first ground member may be connected to the second ground member through at least one of a C-clip, a surface mounted device (SMD) gasket, or a flexible printed circuit board (FPCB).

In addition, the first ground member may include a printed circuit board (PCB) on which the wireless communication circuit and the matching circuit are arranged, and the second ground member may be a metal member configured to support electronic components in the housing of the electronic device.

In addition, the first ground member may include a printed circuit board (PCB) disposed near the conductive portion, and the second ground member may be another PCB spaced apart from the PCB.

In addition, the first ground member may include a PCB disposed around the conductive portion, and the second ground member may include at least one of electronic components in the electronic device.

In addition, the first feeding signal may be fed to the first feeding point and be transmitted to the second ground member through the second filter connected to the second feeding point via at least a part of the conductive portion.

In addition, the second feeding signal may be fed to the second feeding point and be transmitted to the second ground member through the first filter connected to the first feeding point via at least a part of the conductive portion.

According to an embodiment, provided may be an electronic device 101 including: a housing 210 including a side member 218, the side member including a conductive portion operating as an antenna radiator; at least one wireless communication circuit 192 electrically connected to the conductive portion and configured to provide a signal of a designated frequency band; a first ground member 301 disposed in the housing; a second ground member 302 disposed in the housing so as to at least partially overlap the first ground member; a first matching circuit 310 which is disposed on a first feeding line configured to transmit a first feeding signal of a first frequency band provided from the at least one wireless communication circuit to a first feeding point on the conductive portion, and is grounded to the first ground member; a first filter 312 connected to the first feeding point and grounded to the second ground member; a second matching circuit 320 which is disposed on a second feeding line configured to transmit a second feeding signal of a second frequency band provided from the at least one wireless communication circuit to a second feeding point on the conductive portion, and is grounded to the second ground member; and a second filter 322 connected to the second feeding point and grounded to the first ground member.

In addition, the second ground member may be electrically connected to at least one connection point of the first ground member.

In addition, the first frequency band may be higher than the second frequency band, and the distance from the first feeding point to the at least one connection point may be determined based on a wavelength of the first frequency band which is higher than the second frequency band.

In addition, the distance from the first feeding point to the at least one connection point may be longer than 1/4 of a wavelength of the first frequency band.

In addition, the at least one connection point of the first ground member may be connected to the second ground member through at least one switch.

In addition, an operation of the at least one switch may be controlled according to at least one frequency band of the first feeding signal or the second feeding signal which is fed from the at least one wireless communication circuit to the conductive portion.

In addition, the at least one connection point of the first ground member may be connected to the second ground member through at least one of a C-clip, a surface mounted device (SMD) gasket, or a flexible printed circuit board (FPCB).

According to an embodiment, provided may be an electronic device 101 including: a housing 210 including a side member 218, the side member including a conductive portion operating as an antenna radiator; at least one wireless communication circuit 192 electrically connected to the conductive portion and configured to provide a signal of a designated frequency band; a first ground member 301 disposed in the housing; a second ground member 302 disposed to at least partially overlap the first ground member; a third ground member 303 disposed to overlap at least one of the first ground member or the second ground member; a first matching circuit 310 which is disposed on a first feeding line configured to transmit a first feeding signal of a first frequency band provided from the at least one wireless communication circuit to a first feeding point on the conductive portion, and is grounded to the first ground member; multiple first filters 312-1 and 312-2 connected to the first feeding point and grounded to the second ground member and the third ground member, respectively; a second matching circuit 320 which is disposed on a second feeding line configured to transmit a second feeding signal of a second frequency band provided from the at least one wireless communication circuit to a second feeding point on the conductive portion, and is grounded to the first ground member; multiple second filters 322-1 and 322-2 connected to the second feeding point and grounded to the second ground member and the third ground member, respectively; a third matching circuit 340 which is disposed on a third feeding line configured to transmit a third feeding signal of a third frequency band provided from the at least one wireless communication circuit to a third feeding point on the conductive portion, and is grounded to the first ground member; and multiple third filters 332-1 and 332-2 connected to the third feeding point and grounded to the second ground member and the third ground member, respectively.

The electronic device according to various embodiments may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

It should be appreciated that various embodiments of the present disclosure and the terms used therein are not intended to limit the technological features set forth herein to particular embodiments and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used in connection with various embodiments of the disclosure, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

Various embodiments as set forth herein may be implemented as software (e.g., the program 140) including one or more instructions that are stored in a storage medium (e.g., internal memory 136 or external memory 138) that is readable by a machine (e.g., the electronic device 101). For example, a processor (e.g., the processor 120) of the machine (e.g., the electronic device 101) may invoke at least one of the one or more instructions stored in the storage medium, and execute it, with or without using one or more other components under the control of the processor. This allows the machine to be operated to perform at least one function according to the at least one instruction invoked. The one or more instructions may include a code generated by a complier or a code executable by an interpreter. The machine-readable storage medium may be provided in the form of a non-transitory storage medium. Wherein, the term "non-transitory" simply means that the storage medium is a tangible device, and does not include a signal (e.g., an electromagnetic wave), but this term does not differentiate between where data is semi-permanently stored in the storage medium and where the data is temporarily stored in the storage medium.

According to an embodiment, a method according to various embodiments of the disclosure may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store (e.g., PlayStore^{™}), or between two user devices (e.g., smart phones) directly. If distributed online, at least part of the computer program product may be temporarily generated or at least temporarily stored in the machine-readable storage medium, such as memory of the manufacturer's server, a server of the application store, or a relay server.

According to various embodiments, each component (e.g., a module or a program) of the above-described components may include a single entity or multiple entities, and some of the multiple entities may be separately disposed in different components. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

## Claims

1. An electronic device comprising:
a housing (210) comprising a front plate (202) facing a front side of the electronic device, a rear plate (211) facing a rear side of the electronic device, and a side member (218) disposed between the front plate and the rear plate, the side member comprising a conductive portion operating as an antenna radiator;
at least one wireless communication circuit (192) electrically connected to the conductive portion and configured to provide a signal of a designated frequency band;
a first ground member (301) disposed in the housing;
a second ground member (302) disposed in the housing so as to at least partially overlap the first ground member;
a first matching circuit (310) which is disposed on a first feeding line configured to transmit a first feeding signal of a first frequency band provided from the at least one wireless communication circuit to a first feeding point on the conductive portion, and is grounded to the first ground member;
a first filter (312) connected to the first feeding point and grounded to the second ground member;
a second matching circuit (320) which is disposed on a second feeding line configured to transmit a second feeding signal of a second frequency band provided from the at least one wireless communication circuit to a second feeding point on the conductive portion, and is grounded to the first ground member; and
a second filter (322) connected to the second feeding point and grounded to the second ground member.

2. The electronic device of claim 1, wherein the second ground member is electrically connected to at least one connection point of the first ground member.

3. The electronic device of claim 2,
wherein the first frequency band is higher than the second frequency band, and
wherein the distance from the first feeding point to the at least one connection point is determined based on a wavelength of the first frequency band which is higher than the second frequency band.

4. The electronic device of claim 3, wherein the distance from the first feeding point to the at least one connection point is longer than 1/4 of a wavelength of the first frequency band.

5. The electronic device of claim 2, wherein the at least one connection point of the first ground member is connected to the second ground member through at least one switch.

6. The electronic device of claim 5, wherein an operation of the at least one switch is controlled according to at least one frequency band of the first feeding signal or the second feeding signal which is fed from the at least one wireless communication circuit to the conductive portion.

7. The electronic device of claim 2, wherein the at least one connection point of the first ground member is connected to the second ground member through at least one of a C-clip, a surface mounted device (SMD) gasket, or a flexible printed circuit board (FPCB).

8. The electronic device of claim 1,
wherein the first ground member comprises a printed circuit board (PCB) on which the wireless communication circuit and the matching circuit are arranged, and
wherein the second ground member is a metal member configured to support electronic components in the housing of the electronic device.

9. The electronic device of claim 1,
wherein the first ground member comprises a printed circuit board (PCB) disposed near the conductive portion, and
wherein the second ground member is another PCB spaced apart from the PCB.

10. The electronic device of claim 1,
wherein the first ground member comprises a PCB disposed around the conductive portion, and
wherein the second ground member comprises at least one of electronic components in the electronic device.

11. The electronic device of claim 1, wherein the first feeding signal is fed to the first feeding point and is transmitted to the second ground member through the second filter connected to the second feeding point via at least a part of the conductive portion.

12. The electronic device of claim 1, wherein the second feeding signal is fed to the second feeding point and is transmitted to the second ground member through the first filter connected to the first feeding point via at least a part of the conductive portion.

13. An electronic device comprising:
a housing (210) comprising a side member (218), the side member comprising a conductive portion operating as an antenna radiator;
at least one wireless communication circuit (192) electrically connected to the conductive portion and configured to provide a signal of a designated frequency band;
a first ground member (301) disposed in the housing;
a second ground member (302) disposed in the housing so as to at least partially overlap the first ground member;
a first matching circuit (310) which is disposed on a first feeding line configured to transmit a first feeding signal of a first frequency band provided from the at least one wireless communication circuit to a first feeding point on the conductive portion, and is grounded to the first ground member;
a first filter (312) connected to the first feeding point and grounded to the second ground member;
a second matching circuit (320) which is disposed on a second feeding line configured to transmit a second feeding signal of a second frequency band provided from the at least one wireless communication circuit to a second feeding point on the conductive portion, and is grounded to the second ground member; and
a second filter (322) connected to the second feeding point and grounded to the first ground member.

14. The electronic device of claim 13, wherein the second ground member is electrically connected to at least one connection point of the first ground member.

15. The electronic device of claim 14,
wherein the first frequency band is higher than the second frequency band, and
wherein the distance from the first feeding point to the at least one connection point is determined based on a wavelength of the first frequency band which is higher than the second frequency band.
